# EUROPEAN PATENT APPLICATION

(11) **EP 4 715 822 A1**
(43) Date of publication of application: **25.03.2026**
(21) Application number: 25159400.8
(22) Date of filing: 21.02.2025
(51) Int. Cl.: G11C 11/56, G11C 16/26, G11C 16/34, G11C 16/04

(54) **MEMORY SYSTEM AND METHOD OF CONTROLLING MEMORY SYSTEM**

(30) Priority: 19.09.2024 JP 2024162506
(71) Applicant: Kioxia Corporation, Tokyo 108-0023 (JP)
(72) Inventor: Kojima, Hirotaka, Tokyo, 108-0023 (JP); Sakurada, Kenji, Tokyo, 108-0023 (JP)
(74) Representative: Marks & Clerk LLP

(57) **Abstract**

According to one embodiment, a system (1) includes: a memory device including word lines and memory cells (MC0 to MCn-1) connected to word lines (WL0 to WLn-1); and a memory controller(10) , the memory controller acquires first data (DX1, DX2, DX3) related to threshold voltages of selected cells connected to a selected word line among the word lines, acquires second data (RD1L, RD1M, RD1U) from first adjacent cells connected to a first adjacent word line adjacent to one end of the selected word line, acquires first correction data (DY1, DY2, DY3) by correcting the first data based on the second data, acquires third data (RD2L, RD2M, RD2U) from second adjacent cells connected to a second adjacent word line adjacent to another end of the selected word line, acquires second correction data (DZ1, DZ2, DZ3) by correcting the first correction data based on the third data, and executes soft bit decoding processing on the second correction data to generate read data from the selected cells.

## Description

### FIELD

Embodiments described herein relate generally to a memory system and a method of controlling the memory system.

### BACKGROUND

As a memory system, a solid state drive (SSD) including a memory controller and a memory device is known. The memory device is, for example, a nonvolatile memory. The nonvolatile memory is, for example, a NAND flash memory.

### BRIEF DESCRIPTION OF DRAWINGS

FIG. 1 is a block diagram illustrating a configuration example of a memory system according to a first embodiment.
FIG. 2 is a block diagram illustrating a configuration example of a memory device of the memory system of the first embodiment.
FIG. 3 is a circuit diagram illustrating a circuit configuration of a memory cell array of the memory device.
FIG. 4 is a cross-sectional view illustrating a structure example of a NAND string of the memory device.
FIG. 5 is a schematic diagram illustrating an example of a relationship between data and a threshold voltage of a memory cell.
FIG. 6 is a schematic diagram for describing an outline of the memory system of the first embodiment.
FIG. 7 is a flowchart illustrating an operation example of the memory system of the first embodiment.
FIG. 8 is a schematic diagram illustrating a data storage state in a RAM during operation of the memory system of the first embodiment.
FIG. 9 is a schematic diagram illustrating a data storage state in the RAM during the operation of the memory system of the first embodiment.
FIG. 10 is a schematic diagram illustrating an example of data correction in an operation example of the memory system of the first embodiment.
FIG. 11 is a schematic diagram illustrating a data storage state in the RAM during the operation of the memory system of the first embodiment.
FIG. 12 is a schematic diagram illustrating a data storage state in the RAM during the operation of the memory system of the first embodiment.
FIG. 13 is a schematic diagram illustrating a data storage state in the RAM during the operation of the memory system of the first embodiment.
FIG. 14 is a schematic diagram illustrating a data storage state in the RAM during the operation of the memory system of the first embodiment.
FIG. 15 is a schematic diagram illustrating a data storage state in the RAM during the operation of the memory system of the first embodiment.
FIG. 16 is a block diagram illustrating a configuration example of a memory system of a second embodiment.
FIG. 17 is a diagram illustrating an example of a histogram of a selected cell of a certain state and a state of an adjacent cell.
FIG. 18 is a diagram illustrating an example of label values of selected cells obtained by the histogram.
FIG. 19 is a diagram illustrating an example of a correction value table generated based on the histogram.
FIG. 20 is a flowchart illustrating an operation example of the memory system of the second embodiment.
FIG. 21 is a schematic diagram illustrating a data storage state in a RAM during the operation of the memory system of the second embodiment.
FIG. 22 is a schematic diagram illustrating a data storage state in the RAM during the operation of the memory system of the second embodiment.
FIG. 23 is a schematic diagram illustrating a data storage state in the RAM during the operation of the memory system of the second embodiment.

### DETAILED DESCRIPTION

In general, according to one embodiment, a memory system includes: a memory device including a plurality of word lines and a plurality of memory cells connected to each of the plurality of word lines; and a memory controller that controls a read operation of the memory device, wherein the memory controller is configured to: acquire first data related to threshold voltages of a plurality of selected cells connected to a selected word line among the plurality of word lines, acquire second data from a plurality of first adjacent cells connected to a first adjacent word line adjacent to one end of the selected word line among the plurality of word lines, acquire first correction data by correcting the first data based on the second data, acquire third data from a plurality of second adjacent cells connected to a second adjacent word line adjacent to another end of the selected word line among the plurality of word lines, acquire second correction data by correcting the first correction data based on the third data, and execute soft bit decoding processing on the second correction data to generate read data from the plurality of selected cells.

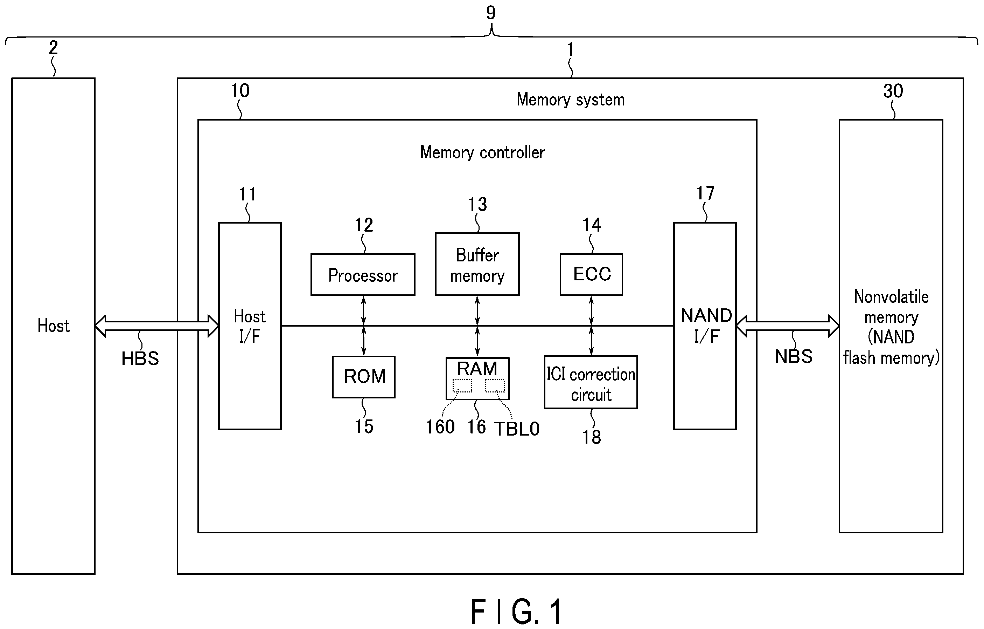

A memory system and a method of controlling the memory system according to an embodiment will be described with reference to FIGS. 1 to 23. In the following description, elements having the same function and configuration are denoted by the same reference numerals. Further, in each of the following embodiments, in a case where the components (for example, circuits, wirings, various voltages and signals, and the like) having a reference with numerals/letters at the end for distinguishing are not necessarily distinguished from each other, a description (reference numeral) in which the numerals/letters at the end are omitted is used. In the following description, data may also be referred to as a data item.

### (Embodiment)

### (1) First Embodiment

A memory system and a method of controlling the memory system according to a first embodiment will be described with reference to FIGS. 1 to 15.

### (a) Configuration Example

### (a-1) Information Processing System

A configuration example of a memory system of the present embodiment will be described with reference to FIG. 1.

FIG. 1 is a block diagram illustrating a configuration example of a device (for example, an information processing system) including a memory system 1 of the present embodiment.

As illustrated in FIG. 1, an information processing system 9 includes a memory system 1 and a host 2 of the present embodiment.

The memory system 1 of the present embodiment is a device that stores data. The memory system 1 is, for example, a solid state drive (SSD), a universal flash storage (UFS) device, a universal serial bus (USB) memory, a multi-media card (MMC), or an SD^{™} card. The memory system 1 can be connected to the host 2 via a host bus HBS. The memory system 1 performs processing based on a request (command or host command) received from the host 2 or a voluntary processing request generated in the memory system 1.

The host 2 is a computing device that controls the memory system 1. The host 2 is, for example, a personal computer, a server system, a mobile device, an in-vehicle device, or a digital camera.

### (a-1-1) Internal Configuration of Memory System

The memory system 1 includes a memory controller 10 and a memory device 30. The memory device 30 is, for example, a nonvolatile memory. The memory device 30 is, for example, a nonvolatile semiconductor memory such as a NAND flash memory. Hereinafter, the memory device 30 is referred to as a nonvolatile memory 30 or a NAND memory 30.

The memory controller 10 is a device that controls the NAND memory 30. The memory controller 10 is connected to the host 2 via a host bus HBS. The memory controller 10 receives a request from the host 2 via the host bus HBS. The type of the host bus HBS depends on an application applied to the memory system 1. In a case where the memory system 1 is an SSD, the host bus HBS conforms to, for example, Serial Attached SCSI (SAS), Serial ATA (SATA), or PCIe^{™} (Peripheral Component Interconnect Express) standards. In a case where the memory system 1 is a UFS device, the host bus HBS conforms to the M-PHY standard. In a case where the memory system 1 is a USB memory, the host bus HBS conforms to the USB standard. In a case where the memory system 1 is an MMC, the host bus HBS conforms to the embedded multi media card (eMMC) standard. In a case where the memory system 1 is an SD^{™} card, the host bus HBS conforms to the SD^{™} standard.

The memory controller 10 controls the NAND memory 30 via a NAND bus NBS based on a request received from the host 2 or a voluntary processing request generated in the memory system 1. The NAND bus NBS conforms to, for example, Toggle NAND Flash Interface standard or Open NAND Flash Interface standard.

The NAND memory 30 is a device that stores data. The NAND memory 30 includes a plurality of memory cells. Each of the plurality of memory cells stores data in a nonvolatile manner according to a threshold voltage of the memory cell. The NAND memory 30 stores data received from the memory controller 10 in a plurality of memory cells in a nonvolatile manner. The NAND memory 30 outputs data read from the plurality of memory cells to the memory controller 10.

### (a-1-2) Memory Controller

An example of an internal configuration of the memory controller 10 will be described.

As illustrated in FIG. 1, the memory controller 10 includes a host interface (I/F) circuit 11, a processor 12, a buffer memory 13, an error checking and correcting (ECC) circuit 14, a read only memory (ROM) 15, a random access memory (RAM) 16, a NAND interface (I/F) circuit 17, and an inter-cell interference (ICI) correction circuit 18. The memory controller 10 can be configured as, for example, a system-on-a-chip (SoC).

The host interface circuit 11 is a circuit that manages communication between the memory controller 10 and the host 2. The host interface circuit 11 is connected to the host 2 via a host bus HBS.

The processor 12 is a control circuit of the memory controller 10. The processor 12 is, for example, a central processing unit (CPU). The processor 12 controls the entire operation of the memory controller 10 by executing a program (firmware) stored in the ROM 15. For example, when receiving a write request from the host 2, the processor 12 controls a write operation based on the received write request. The same applies to a read operation and an erase operation.

The buffer memory 13 is a memory that temporarily stores data. The buffer memory 13 is, for example, a static random access memory (SRAM). The buffer memory 13 temporarily stores write data, read data, and the like. The write data is data to be written to the NAND memory 30. The read data is data read from the NAND memory 30.

The ECC circuit 14 is a circuit that performs error checking and correcting (ECC) processing for data error correction. The ECC circuit 14 generates an error correction code based on the write data during the data write operation. The ECC circuit 14 generates a syndrome based on an error correction code in a predetermined unit and detects an error during a data read operation. The ECC circuit 14 corrects the detected error.

For example, the ECC circuit 14 performs a hard bit decoding process and a soft bit decoding process. The ECC circuit 14 can execute hard bit decoding using a Reed-Solomon (RS) code or a Bose-Chaudhuri-Hocquenghem (BCH) code. The ECC circuit 14 can execute soft bit decoding using a low density parity-check (LDPC) code of data.

The ROM 15 is a nonvolatile memory. The ROM 15 is, for example, an EEPROM^{™} (Electrically Erasable Programmable Read-Only Memory). The ROM 15 stores programs such as firmware.

The RAM 16 is a volatile memory. The RAM 16 is, for example, an SRAM or a dynamic random access memory (DRAM). The RAM 16 is used as a work area of the processor 12. The RAM 16 stores firmware for managing the NAND memory 30 and various types of management information. The RAM 16 stores, for example, a table TBLO including various types of information. For example, the table TBLO includes information related to correction of data read from the NAND memory 30. The RAM 16 includes a memory area 160 for temporarily storing data read by the read operation of the NAND memory 30. Note that the table TBLO may be stored in the processor 12. The memory area 160 is an area having a predetermined storage capacity secured for storing various data used for soft bit decoding reading to be described later.

The NAND interface circuit 17 is a circuit that manages communication between the memory controller 10 and the NAND memory 30. The NAND interface circuit 17 is connected to the NAND memory 30 via the NAND bus NBS. For example, the NAND interface circuit 17 controls transfer of data, commands, addresses, and the like between the memory controller 10 and the NAND memory 30.

The ICI correction circuit 18 is a circuit that executes various types of processing for correcting read data according to the magnitude of an interference generated between memory cells so that the influence of interference between the memory cells in the read data is alleviated at the time of reading the data. Note that the ICI correction circuit 18 may be provided in the processor 12 or the ECC circuit 14 as a functional block.

### (a-1-3) NAND Flash Memory

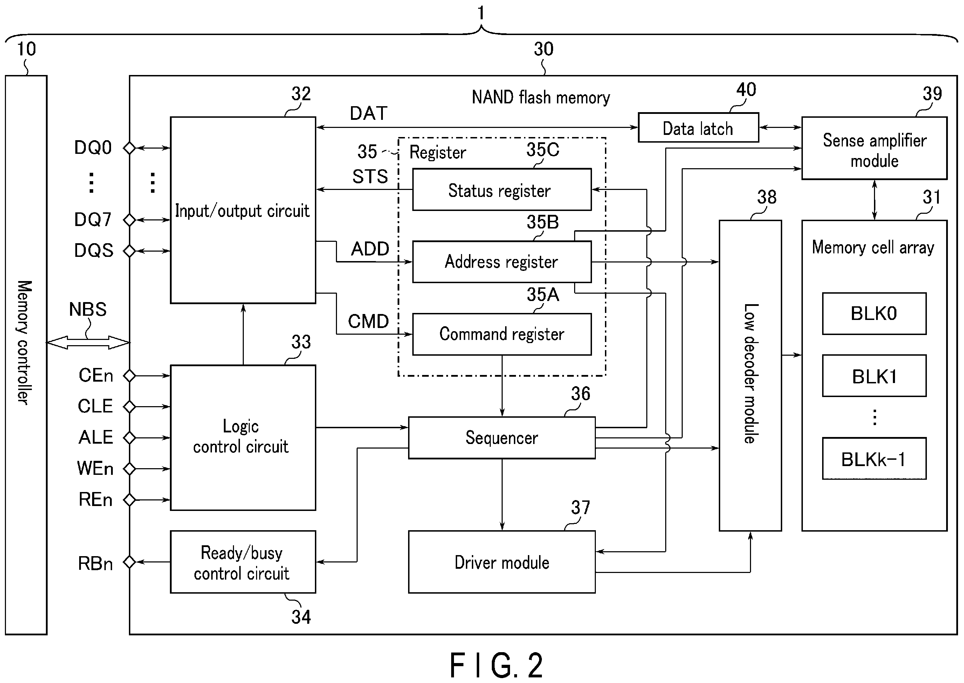

A configuration of the NAND memory 30 will be described with reference to FIG. 2.

FIG. 2 is a block diagram illustrating an example of a configuration of the NAND memory 30. The NAND memory 30 includes a memory cell array 31, an input/output circuit 32, a logic control circuit 33, a ready/busy control circuit 34, a register 35, a sequencer 36, a driver module 37, a row decoder module 38, a sense amplifier module 39, and a data latch 40.

The memory cell array 31 includes one or more blocks BLK (BLK0, BLK1, ..., BLKk-1). k is an integer equal to or more than 1. The block BLK is, for example, a set of a plurality of memory cells from which data is collectively erased. For example, the block BLK is used as a unit of a data erase operation. A plurality of bit lines and a plurality of word lines are provided in the memory cell array 31. Each memory cell is associated with, for example, one bit line and one word line. Details of the memory cell array 31 will be described later.

The input/output circuit 32 is a circuit that transmits and receives signals and information to and from the memory controller 10. The input/output circuit 32 transmits/receives an input/output signal DQ (for example, 8-bit signals DQ0 to DQ7) and a data strobe signal DQS to/from the memory controller 10. The signal DQ is an entity of data transmitted and received between the NAND memory 30 and the memory controller 10. The signal DQ is, for example, a command CMD, an address ADD, status information STS, and data DAT. The signal DQS is a signal (clock signal) for controlling the transmission/reception timing of the signal DQ. For example, at the time of writing data, the signal DQS is transmitted from the memory controller 10 to the NAND memory 30 together with the signal DQ including the write data. The NAND memory 30 receives the signal DQ including the write data in synchronization with the signal DQS. At the time of reading data, the signal DQS is transmitted from the NAND memory 30 to the memory controller 10 together with the signal DQ including the read data. The memory controller 10 receives the signal DQ including the read data in synchronization with the signal DQS. Note that the input/output circuit 32 may receive the signal DQS from the memory controller 10 via the logic control circuit 33.

The input/output circuit 32 transmits the command CMD in the signal DQ to a command register 35A. The input/output circuit 32 transmits the address ADD in the signal DQ to an address register 35B. The input/output circuit 32 receives the status information STS from the status register 35C. The input/output circuit 32 transmits/receives the data DAT in the signal DQ to/from the data latch 40.

The logic control circuit 33 is a circuit that controls the input/output circuit 32 and the sequencer 36 based on a control signal. The logic control circuit 33 receives a chip enable signal CEn, a command latch enable signal CLE, an address latch enable signal ALE, a write enable signal WEn, and a read enable signal REn from the memory controller 10. The signal CEn is a signal for enabling the chip of the NAND memory 30. The signal CLE is a signal indicating that the signal DQ received by the NAND memory 30 is the command CMD. The signal ALE is a signal indicating that the signal DQ received by the NAND memory 30 is the address ADD. The signal WEn is a signal that orders the NAND memory 30 to input the signal DQ. The signal REn is a signal that orders the NAND memory 30 to output the signal DQ. The NAND memory 30 generates a signal DQS based on the signal REn. The NAND memory 30 outputs a signal DQ to the memory controller 10 based on the generated signal DQS.

The ready/busy control circuit 34 is a circuit that notifies the memory controller 10 of the operation status of the sequencer 36. The ready/busy control circuit 34 transmits a ready/busy signal RBn to the memory controller 10 based on the operation status of the sequencer 36. The signal RBn is a signal indicating whether the NAND memory 30 is in a ready state or a busy state. The signal level of the signal RBn is, for example, the "High" level ("H" level) when the NAND memory 30 is in the ready state. The ready state is a state in which the NAND memory 30 can receive the command CMD from the memory controller 10. The signal level of the signal RBn is set to a "Low" level ("L" level) when the NAND memory 30 is in a busy state, for example. The busy state is a state in which the NAND memory 30 cannot receive the command CMD from the memory controller 10.

The register 35 is a circuit that temporarily stores information. The register 35 includes a command register 35A, an address register 35B, and a status register 35C.

The command register 35A is a circuit that stores the command CMD. The command CMD includes, for example, a command for causing the sequencer 36 to execute a read operation, a write operation, or an erase operation.

The address register 35B is a circuit that stores the address ADD. The address ADD includes, for example, a row address and a column address. The row address includes a block address and a page address (word line address). The block address, the page address, and the column address are used, for example, to select the block BLK, the word line, and the bit line, respectively.

The status register 35C is, for example, a circuit that temporarily stores the status information STS in the read operation, the write operation, or the erase operation. The status information STS is used to notify the memory controller 10 whether or not the operation has been normally ended.

The sequencer 36 is a circuit that controls the operation of other circuits according to a predetermined program. The sequencer 36 controls the entire operation of the NAND memory 30. For example, the sequencer 36 controls the ready/busy control circuit 34, the driver module 37, the row decoder module 38, and the sense amplifier module 39 based on the command CMD stored in the command register 35A. For example, the sequencer 36 executes a read operation, a write operation, and an erase operation.

The driver module 37 is a circuit that generates a voltage used in the read operation, the write operation, and the erase operation. The driver module 37 applies the generated voltage to the signal line corresponding to the selected word line based on the page address stored in the address register 35B.

The row decoder module 38 is a circuit that selects one block BLK in the memory cell array 31 based on the block address stored in the address register 35B. The row decoder module 38 transfers the voltage applied to the signal line corresponding to the selected word line to the selected word line in the selected block BLK.

In the write operation, the sense amplifier module 39 receives write data DAT from the input/output circuit 32 via the data latch 40. The sense amplifier module 39 applies a voltage based on the received write data DAT to the bit line. In the read operation, the sense amplifier module 39 determines data stored in the memory cell based on the presence or absence of generation of a current in the bit line or the voltage of the bit line. The sense amplifier module 39 transfers the determination result as read data DAT to the input/output circuit 32 via the data latch 40.

The data latch (data cache) 40 includes a plurality of latch circuits (not illustrated). Each latch circuit temporarily stores write data or read data. For example, in the write operation, the data latch 40 temporarily stores the write data received from the input/output circuit 32 and transmits the write data to the sense amplifier module 39. Further, in the read operation, the data latch 40 temporarily stores the read data received from the sense amplifier module 39 and transmits the read data to the input/output circuit 32.

### <Configuration Example of Memory Cell Array>

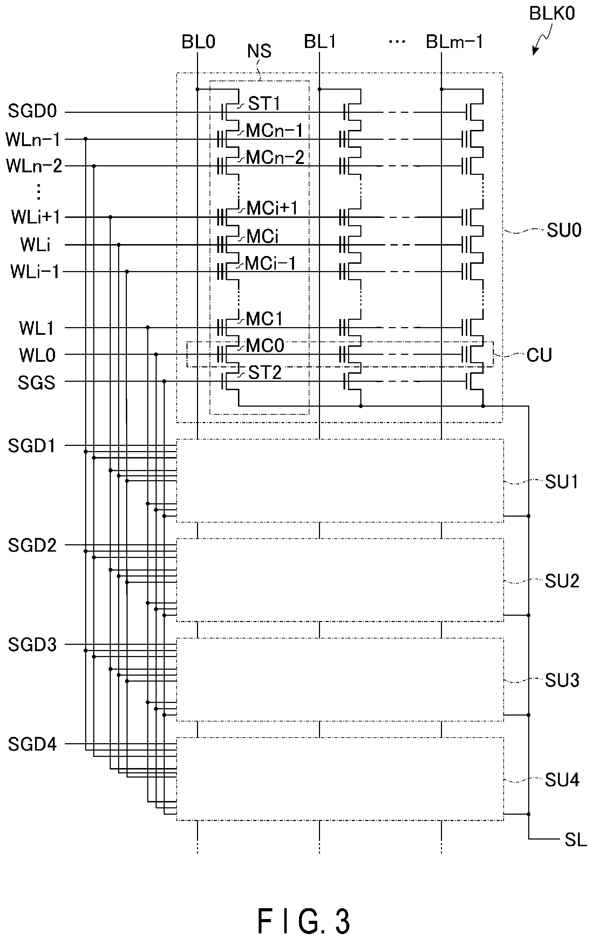

A circuit configuration of the memory cell array 31 will be described with reference to FIG. 3. FIG. 3 is a circuit diagram of the memory cell array 31. FIG. 3 illustrates a circuit configuration of the block BLK0 included in the memory cell array 31 as an example of a circuit configuration of the memory cell array 31. The other blocks BLK also have the same configuration as that of FIG. 3.

The block BLK0 includes, for example, five string units SU0, SU1, SU2, SU3, and SU4. Each string unit SU is, for example, a set of a plurality of NAND strings NS collectively selected in the write operation or the read operation. Each string unit SU includes a plurality of NAND strings NS respectively associated with bit lines BL0, BL1, ..., BLm-1. m is an integer equal to or more than 1.

The NAND string NS is a set of a plurality of memory cells connected in series. Each NAND string NS includes, for example, a memory cell MC (MC0, MC1, ..., MCi-1, MCi, MCi+1, ..., MCn-2, and MCn-1), a select transistor ST1, and a select transistor ST2. n is an integer equal to or more than 1. i is an integer equal to or more than 0 and equal to or less than n-1.

The memory cell (also referred to as a memory cell transistor) MC is a field effect transistor including a control gate and a charge storage layer. The select transistors ST1 and ST2 are switching elements. Each of the select transistors ST1 and ST2 is used to select the string unit SU during various operations.

In each NAND string NS, the plurality of memory cells MC0, ..., MCn-1 is connected in series. The drain of the select transistor ST1 is connected to the associated bit line BL. The source of the select transistor ST1 is connected to one ends of the memory cells MC0, ..., MCn-1 connected in series. The drain of the select transistor ST2 is connected to the other ends of the memory cells MC0, **...,** MCn-1 connected in series. The source of the select transistor ST2 is connected to a source line SL.

In the same block BLK, the control gates of the memory cells MC0, MC1, ..., MCi-1, MCi, MCi+1, ..., MCn-2, and MCn-1 are commonly connected to the word lines WL0, WL1, WL2, WL3, ..., WLi-1, WLi, WLi+1, ..., WLn-2, and WLn-1, respectively, among the plurality of NAND strings. The gates of the select transistors ST1 in the string units SU0, SU1, SU2, SU3, and SU4 are commonly connected to select gate lines SGD0, SGD1, SGD2, SGD3, and SGD4 among the plurality of NAND strings, respectively. The gates of the select transistors ST2 included in the same block BLK are commonly connected to a select gate line SGS among the plurality of NAND strings.

In the circuit configuration of the memory cell array 31 described above, the bit line BL is shared by, for example, the NAND string NS to which the same column address is allocated in each string unit SU. The source line SL is shared among the plurality of blocks BLK, for example.

Hereinafter, among the plurality of word lines WL0, ..., WLn-1, the word line WL0 located closest to the source side of the NAND string NS is referred to as a start word line WL0, and the word line WLn-1 located closest to the drain side of the NAND string NS is referred to as an end word line WLn-1. The word lines WL1, ..., WLn-2 other than the start and end word lines WL0 and WLn-1 are referred to as intermediate word lines WL1, ..., WLn-2.

For example, in a case where the word line WLi is an intermediate word line, the word line WLi-1 is provided between the word line WLi and the source line SL. The address value of the word line WLi-1 is different from the address value of the word line WLi by 1. For example, the address value (for example, the value of the physical address) of the word line WLi-1 is smaller than the address value of the word line WLi by 1. For example, in a case where the word line WLi is an intermediate word line, the word line WLi+1 is provided between the word line WLi and the bit line BL. The address value (for example, the value of the physical address) of the word line WLi+1 is different from the address value of the word line WLi by 1. For example, the address value of the word line WLi+1 is larger than the address value of the word line WLi by 1. Note that, depending on the setting of the address, the address value of the word line WLi-1 may be larger than the address value of the word line WLi by 1, and the address value of the word line WLi+1 may be smaller than the address value of the word line WLi by 1.

A set of a plurality of memory cells MC connected to a common word line WL in one string unit SU is referred to as, for example, a cell unit CU. The block BLK includes a plurality of cell units CU. Data stored in a cell unit CU including a plurality of memory cells MC each storing 1-bit data according to the threshold voltage corresponds to 1-page data. The cell unit CU can store data of two or more pages based on the number of bits of data stored in the memory cell MC. In the present embodiment, one memory cell MC can store 3-bit data. That is, the memory cell MC in the present embodiment is a triple level cell (TLC) that stores 3-bit data. In this case, data stored in one cell unit CU corresponds to 3-page data.

Note that the number of bits of data that can be stored in the memory cell MC may be any real number. For example, the memory cell MC may be a multi level cell (MLC) that stores 2-bit data, a quad level cell (QLC) that stores 4-bit data, or a penta level cell (PLC) that stores 5-bit data.

Further, the circuit configuration of the memory cell array 31 is not limited to the above-described configuration. For example, the number of string units SU included in each block BLK and the number of memory cells MC and select transistors ST1 and ST2 included in each NAND string NS may be any number.

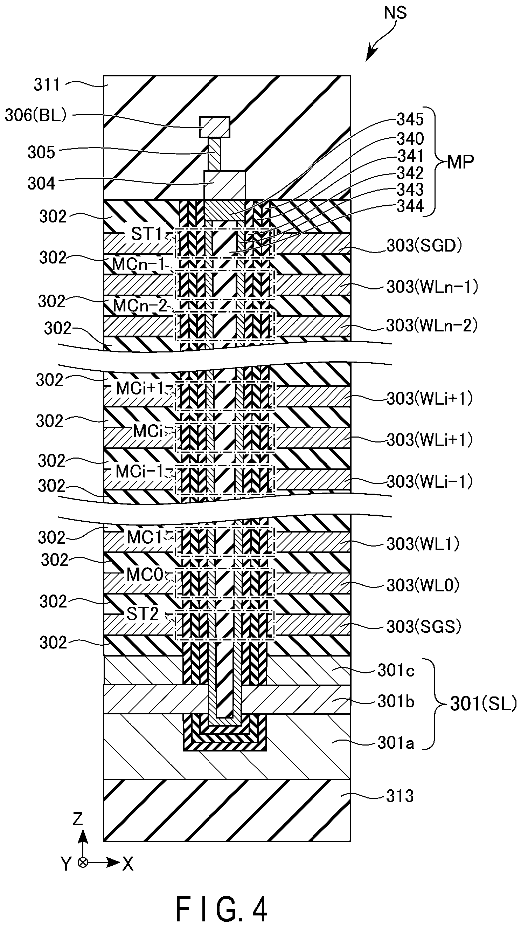

The structure of the NAND string NS of the memory cell array 31 will be described with reference to FIG. 4.

FIG. 4 is a cross-sectional view illustrating an example of a structure of the NAND string NS included in the memory cell array 31. In FIG. 4, one NAND string NS is extracted and illustrated.

As illustrated in FIG. 4, the NAND string NS includes a semiconductor layer 301. The semiconductor layer 301 is provided on the insulating layer 313. The semiconductor layer 301 includes, for example, three semiconductor layers 301a, 301b, and 301c. The three semiconductor layers 301a, 301b, and 301c function as the source line SL. The semiconductor layer 301a is provided on the insulating layer 313. The semiconductor layer 301b is provided on the semiconductor layer 301a. The semiconductor layer 301c is provided on the semiconductor layer 301b. The semiconductor layers 301a, 301b, and 301c include, for example, silicon. The semiconductor layers 301a, 301b, and 301c include, for example, phosphorus (P) as an impurity of the semiconductor.

The NAND string NS includes a plurality of insulating layers 302 and a plurality of conductive layers 303. The plurality of insulating layers 302 and the plurality of conductive layers 303 are stacked on the semiconductor layer 301 in an Z direction. A plurality of insulating layers 302 and a plurality of conductive layers 303 are alternately stacked one by one above the semiconductor layer 301c. The conductive layer 303 has a plate-like structure extending in an X direction and a Y direction.

In the example of FIG. 4, each of the conductive layers 303 functions as a select gate line SGS, word lines WL0, WL1, ..., WLi-1, WLi, WLi+1, ..., WLn-2, and WLn-1, and a select gate line SGD in this order from the side closer to the semiconductor layer 301 (source line SL). Note that each of the select gate lines SGS and SGD may include a plurality of conductive layers 303.

In a case where the plurality of conductive layers 303 is stacked in the Z direction, the plurality of word lines WL0, WL1, ..., WLi-1, WLi, WLi+1, ..., WLn-2, and WLn-1 are arranged in the Z direction. The word lines WL are adjacent to each other in a direction (Z direction) intersecting with the extending direction (X direction and Y direction) of the word lines WL. For example, the word line WLi is provided between the two word lines WLi-1 and WLi+1 in the Z direction. The word line WL-i is adjacent to the word line WLi on the source side (one end of the word line WLi in the Z direction) of the NAND string NS. The word line WL-i is located below the word line WLi in the Z direction. The word line WL+i is adjacent to the word line WLi on the drain side of the NAND string NS (the other end of the word line WLi in the Z direction). The word line WL+i is located above the word line WLi in the Z direction.

For example, a stacked structure of titanium nitride (TiN)/tungsten (W) can be used as the conductive material of the conductive layer 303. In this case, titanium nitride is formed so as to cover tungsten. Titanium nitride has a function as a barrier layer for suppressing oxidation of tungsten and/or an adhesion layer for improving adhesion of tungsten at the time of forming tungsten by, for example, chemical vapor deposition (CVD). The conductive layer 303 may include a high dielectric constant material such as aluminum oxide (AlO). In this case, the high dielectric constant material is formed so as to cover the conductive material between the insulating layers 302.

The NAND string NS includes a memory pillar MP. The memory pillar MP extends in the Z direction. The memory pillar MP penetrates the plurality of insulating layers 302 and the plurality of conductive layers 303 in the Z direction. A bottom portion (one end) of the memory pillar MP reaches the semiconductor layer 301. The memory pillar MP may have a structure in which a plurality of pillars is connected in the Z direction.

The memory pillar MP includes a block insulating layer 340, a charge storage layer 341, a tunnel insulating layer 342, a semiconductor layer 343, a core layer 344, and a cap layer 345.

The charge storage layer 341 is a layer capable of storing charges. The charge storage layer 341 includes, for example, silicon nitride. The tunnel insulating layer 342 is a layer through which charges pass due to a tunnel phenomenon if a voltage equal to or higher than a threshold is applied to the conductive layer 303. The block insulating layer 340 is a layer that blocks charges in the charge storage layer 341 from moving to the conductive layer 303.

The semiconductor layer 343 is a region in which current paths (channels) of the memory cell MC and the select transistors ST1 and ST2 are formed. A side surface of the semiconductor layer 343 is covered with the block insulating layer 340, the charge storage layer 341, and the tunnel insulating layer 342 in this order from the outside of the memory pillar MP. The semiconductor layer 343 covers the side surface and the bottom surface of the core layer 344. The semiconductor layer 343 includes, for example, silicon.

In the same layer as the semiconductor layer 301b and in the vicinity of the semiconductor layer 301b, the block insulating layer 340, the charge storage layer 341, and the tunnel insulating layer 342 on the side surface of the memory pillar MP are removed. The semiconductor layer 343 is in contact with the semiconductor layer 301b via a portion from which the block insulating layer 340, the charge storage layer 341, and the tunnel insulating layer 342 are removed.

The core layer 344 is a core material of the memory pillar MP. In the core layer 344 includes, for example, silicon oxide.
the cap layer 345 is provided so as to cover ends of the semiconductor layer 343 and the core layer 344 at an upper portion (the other end) of the memory pillar MP in the Z direction. The side surface of the cap layer 345 is in contact with the tunnel insulating layer 342. The cap layer 345 contains, for example, silicon.

A conductor 304 is provided on the cap layer 345. A conductor 305 is provided on the conductor 304. The conductor 305 is connected to the conductive layer 306 as the bit line BL. The conductive layer 306 extends in the Y direction. The conductors 304 and 305 and the conductive layer 306 are provided in an insulating layer 311.

The plurality of conductive layers 303 as the word lines WL is arranged in the Z direction between the semiconductor layer 301 as the source line SL and the conductive layer 306 as the bit line BL.

A combination of the memory pillar MP and the conductive layer 303 as the word line WL (WL0, WL1, ..., WLi-1, WLi, WLi+1, **...,** WLn-2, and WLn-1) constitutes a memory cell MC (MC0, MC1, **...,** MCi-1, MCi, MCi+1, **...,** MCn-2, and MCn-1). The select transistor ST1 is configured by a combination of the memory pillar MP and the conductive layer 303 as the select gate line SGD. The select transistor ST2 is configured by a combination of the memory pillar MP and the conductive layer 303 as the select gate line SGS. Thus, each memory pillar MP can function as one NAND string NS.

Data stored in the memory cell MC depends on the amount of charges stored in the charge storage layer 341.

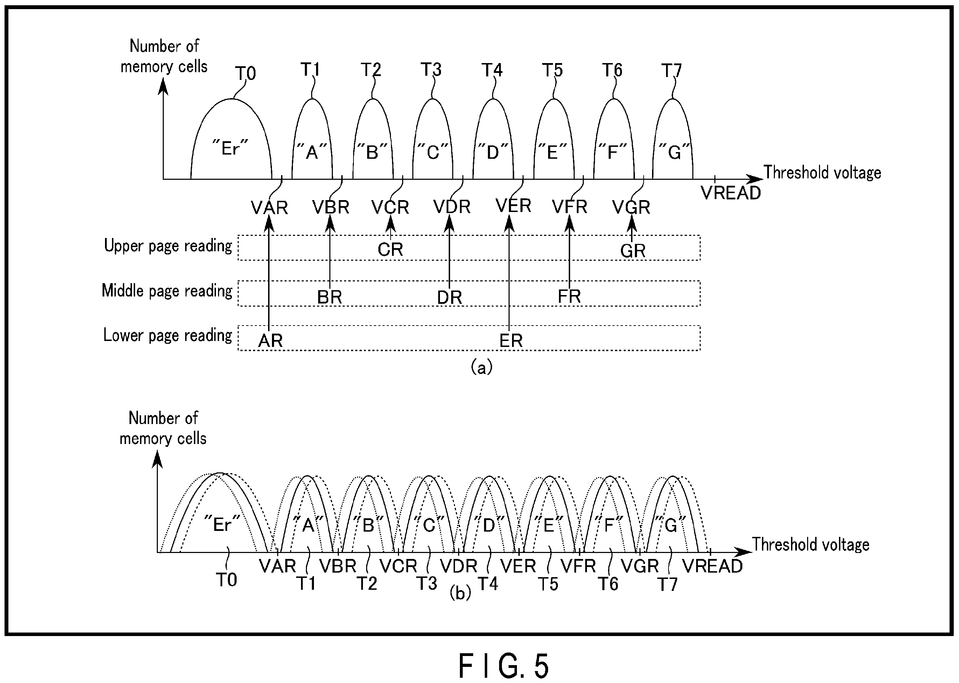

The relationship between the data stored in the memory cell MC and the threshold voltage of the memory cell MC will be described with reference to FIG. 5.

In this example, one memory cell MC can store 3-bit data. Hereinafter, the 3-bit data is referred to as a lower bit, a middle bit, and an upper bit in order from a lower bit. A set of lower bits stored in the memory cells MC belonging to the same cell unit CU is referred to as a lower page (or lower data), a set of middle bits is referred to as a middle page (or middle data), and a set of upper bits is referred to as an upper page (or upper data).

For example, three pages are allocated to one word line WL (one cell unit CU) in one string unit SU. In other words, the "page" can be defined as a part of the memory space formed in the cell unit CU. Writing and reading of data may be performed for each page or each cell unit CU. (a) of FIG. 5 is a diagram illustrating data that can be taken by each memory cell MC, a threshold voltage distribution, and a voltage used when data is read.

As illustrated in (a) of FIG. 5, if the memory cell MC can store 3-bit data, the memory cell MC can take eight states according to the threshold voltage. These eight states are referred to as an "Er" state T0, an "A" state T1, a "B" state T2, a "C" state T3, a "D" state T4, an "E" state T5, an "F" state T6, and a "G" state T7 in order from a low threshold voltage.

The threshold voltage of the memory cell MC in the "Er" state T0 is less than a voltage VAR and corresponds to a data erase state. The threshold voltage of the memory cell MC in the "A" state T1 is equal to or more than the voltage VAR and less than a voltage VBR (> VAR). The threshold voltage of the memory cell MC in the "B" state T2 is equal to or more than the voltage VBR and less than a voltage VCR (> VBR). The threshold voltage of the memory cell MC in the "C" state T3 is equal to or more than the voltage VCR and less than a voltage VDR (> VCR). The threshold voltage of the memory cell MC in the "D" state T4 is equal to or more than the voltage VDR and less than a voltage VER (> VDR). The threshold voltage of the memory cell MC in the "E" state T5 is equal to or more than the voltage VER and less than a voltage VFR (> VER). The threshold voltage of the memory cell MC in the "F" state T6 is equal to or more than the voltage VFR and less than a voltage VGR (> VFR). The threshold voltage of the memory cell MC in the "G" state T7 is equal to or more than the voltage VGR and less than a voltage VREAD (> VGR).

Among the eight states T0, ..., T7 distributed in this manner, the "G" state T7 is the state having the highest threshold voltage. Each state T0, ..., T7 has a range of voltage values associated with the corresponding data. The "Er" state T0 is referred to as an erase state. The states T1, ..., T7 from "A" to "G" are called program states.

Hereinafter, each of the voltages VAR, **...,** VGR is also referred to as a read level or a determination level.

The read levels VAR, **...,** VGR are used as reference voltages in hard bit decoding reading. Further, the read levels VAR, **...,** VGR are used as reference voltages for setting a voltage section (shift voltage) in soft bit decoding reading.

The voltage VREAD is, for example, a voltage applied to a word line (non-selected word line) WL not to be read during the read operation. If the voltage VREAD is applied to the memory cell MC, the memory cell MC is turned on regardless of the stored data of the memory cell MC.

The threshold voltage distribution corresponding to each of the states T0, ..., T7 is implemented by writing 3-bit (3 pages) data including the lower bit, the middle bit, and the upper bit to the memory cell MC in the memory cell array 31. An example of the relationship between the state of the threshold voltage and the lower/middle/upper bits is as follows.
"Er" state: "111" (represented in the order of "upper/middle/lower")
"A" state: "110"
"B" state: "100"
"C" state: "000"
"D" state: "010"
"E" state: "011"
"F" state: "001"
"G" state: "101"

As described above, only one bit of three bits changes between data corresponding to two adjacent states in the threshold voltage distribution.

For reading the lower bit, it is sufficient if a voltage corresponding to a boundary where the value ("0" or "1") of the lower bit changes is used. For reading the upper bit, it is sufficient if a voltage corresponding to a boundary where the value of the upper bit changes is used. For reading the middle bit, it is sufficient if a voltage corresponding to a boundary where the value of the middle bit changes is used.

As illustrated in (a) of FIG. 5, reading of the lower page is executed using the voltage VAR for distinguishing between the "Er" state T0 and the "A" state T1 and the voltage VER for distinguishing between the "D" state T4 and the "E" state T5 as the read voltages.

The reading of the middle page is executed using the voltage VBR for distinguishing between the "A" state T1 and the "B" state T2, the voltage VDR for distinguishing between the "C" state T3 and the "D" state T4, and the voltage VFR for distinguishing between the "E" state T5 and the "F" state T6 as read voltages.

The upper page is read using the voltage VCR for distinguishing between the "B" state T2 and the "C" state T3 and the voltage VGR for distinguishing between the "F" state T6 and the "G" state T7 as read voltages.

The memory cell MC in the erased state is specified by reading using the voltage VAR.

Hereinafter, reading (determination) using the voltage VAR is also referred to as AR reading. Similarly, reading using the voltages VBR, VCR, VDR, VER, VFR, and VGR is referred to as BR reading, CR reading, DR reading, ER reading, FR reading, and GR reading, respectively. (b) of FIG. 5 is a diagram for describing a state of the threshold voltage distribution of the memory cell.

The threshold voltages of the adjacent memory cells MC affect each other according to the magnitudes of the threshold voltages of the memory cells MC. The threshold voltages of the memory cells MC are shifted by the ICI between the memory cells MC. For example, if the threshold voltage of a memory cell (hereinafter referred to as an adjacent cell) adjacent to a memory cell (hereinafter referred to as a selected cell) selected as a read target is lower than the threshold voltage of the selected cell MC (for example, if the state of the adjacent cell is the "Er" state), the threshold voltage of the selected cell MC is shifted to the low voltage side as in the threshold voltage distribution indicated by a dotted line in (b) of FIG. 5. If the threshold voltage of the adjacent cell is higher than the threshold voltage of the selected cell (for example, if the state of the adjacent cell is the "G" state), the threshold voltage of the selected cell MC shifts to the high voltage side as in a threshold voltage distribution indicated by a broken line in (b) of FIG. 5.

If the threshold voltage distribution changes due to such a variation factor caused by ICI, adjacent threshold voltage distributions may overlap.

Since the adjacent threshold voltage distributions overlap, the read operation of hard bit decoding using the voltages VAR, VBR, VCR, ..., VFR, and VGR may not correctly read the data from the memory cell having the threshold voltage in the region where the distributions overlap.

For example, if the threshold voltage distribution in the "A" state T1 and the threshold voltage distribution in the "B" state T2 overlap, a memory cell having a threshold voltage higher than the voltage VBR among memory cells having the threshold voltage distribution in the "A" state T1 may be erroneously read as the "B" state T2, and a memory cell having a threshold voltage lower than the voltage VBR among memory cells having the threshold voltage distribution in the "B" state T2 may be erroneously read as the "A" state T1. As described above, if the number of erroneously read bits (the number of error bits) exceeds the number of correctable bits of the ECC circuit 14, the memory controller 10 fails to read correct data from the NAND memory 30.

In the memory system 1 of the present embodiment, in order to reduce errors of data caused by ICI in reading of data by soft bit decoding, ICI cancellation correction for correcting data read from the selected cell is executed according to the threshold voltage (state) of the adjacent cell.

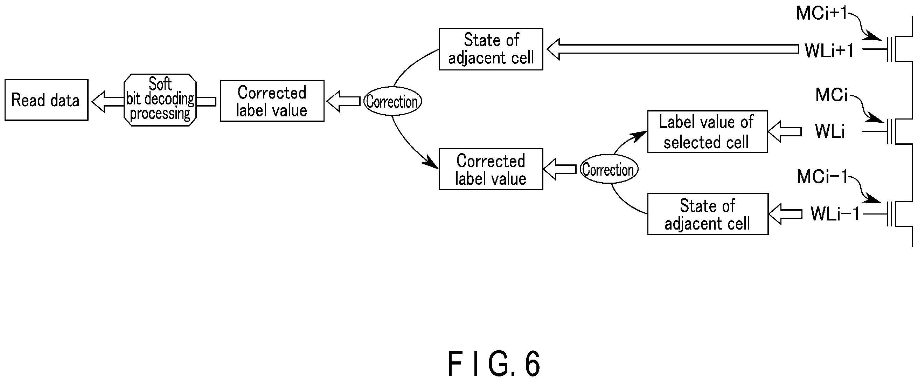

An outline of the memory system 1 of the present embodiment will be described with reference to FIG. **6****.**

FIG. 6 is a schematic diagram illustrating an outline of the memory system 1 of the present embodiment.

When executing the read operation of soft bit decoding, the memory system 1 of the present embodiment executes the ICI cancellation correction on data read from a plurality of selected cells MCi of a word line that is selected (hereinafter referred to as selected word line) WLi in the memory controller 10.

In the read operation of soft bit decoding, the threshold voltage of the selected cell MCi is estimated based on information obtained from the measurement operation (for example, distribution read described below) of the threshold voltage of the selected cell MCi. In the memory controller 10, the estimated magnitude of the threshold voltage of each selected cell MCi is indicated by a label value. The label value is a digital value.

At the time of executing the ICI cancellation correction on the data read from the selected cell MCi of the selected word line WLi, the memory system 1 of the present embodiment executes the read operation for determining the threshold voltages of the memory cells (adjacent cells) MCi-1 and MCi+1 connected to the adjacent word lines WLi-1 and WLi+1 on each of the word line (hereinafter referred to as a source-side adjacent word line) WLi-1 adjacent to the selected word line WLi on the source side (source line side) of the NAND string NS and the word line (hereinafter referred to as drain-side adjacent word line) WLi+1 adjacent to the selected word line WLi on the drain side (bit line side) of the NAND string NS. Thus, the states of the adjacent cells MCi-1 and MCi+1 are determined.

The memory system 1 of the present embodiment corrects the label value according to the read data from the selected cell MCi of the selected word line WLi by the first ICI cancellation correction based on the read result (the state of the adjacent cell) for one adjacent word line (for example, the adjacent word line WLi-1).

Thereafter, the memory system 1 of the present embodiment corrects the label value of the selected cell MCi of the selected word line WLi again by the second ICI cancellation correction based on the read result (the state of the adjacent cell) for the other word line (for example, the adjacent word line WLi+1).

For example, in a case where the memory cell MC is the TLC, the threshold voltage of a certain adjacent cell MC of the adjacent word line WL belongs to any one of eight threshold voltage distributions. Therefore, eight patterns of states (threshold voltage distribution) can be taken by one adjacent cell MCi-1 of the source-side adjacent word line WLi-1.

In the first ICI cancellation correction, the label value (data, threshold voltage) of one selected cell MCi is corrected using any one of eight patterns of correction values according to the pattern of the threshold voltage distribution (state) of the adjacent cell MCi-1.

Similarly, eight patterns of states can be taken by one adjacent cell MCi+1 of the drain-side adjacent word line WLi+1.

In the second ICI cancellation correction, the corrected label value of one selected cell MCi is corrected again using any one of eight patterns of correction values according to the pattern of the threshold voltage distribution of the adjacent cell MCi+1.

In this manner, the data of each selected cell MCi of the selected word line WLi is corrected by the ICI cancellation correction using the correction values of the 8×8 (= 64) patterns.

As a result, the memory system 1 of the present embodiment can improve the reliability of the read data.

### (b) Operation Example

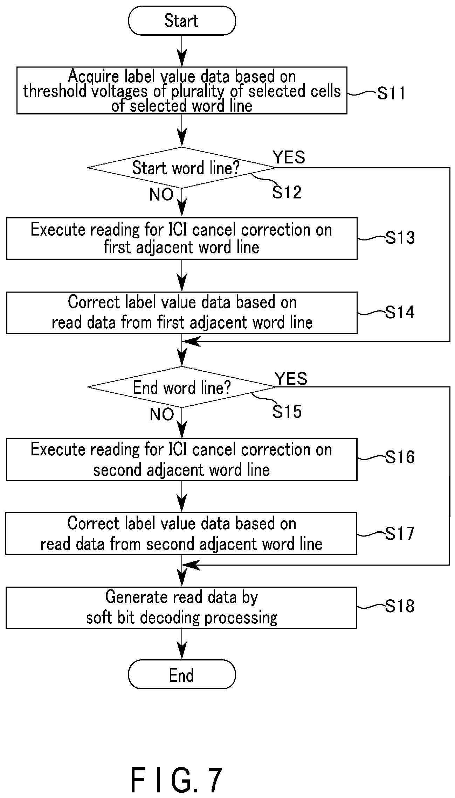

An operation example of the memory system 1 of the present embodiment will be described with reference to FIGS. 7 to 15. Note that the operation example of the memory system 1 of the present embodiment corresponds to the control method of the memory system 1 of the present embodiment.

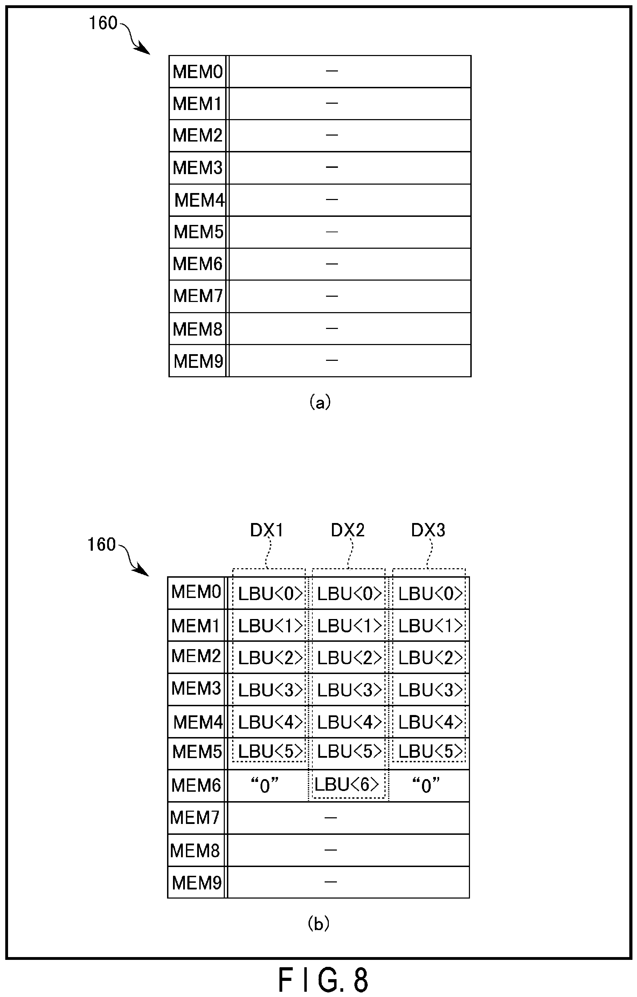

FIG. 7 is a flowchart of an operation example of the memory system 1 of the present embodiment. FIGS. 8 to 15 are schematic diagrams for describing an operation example of the memory system 1 of the present embodiment.

The memory system 1 of the present embodiment starts reading of data by soft bit decoding if reading of data by hard bit decoding fails.

### <S11>

The memory system 1 samples the threshold voltages (threshold voltage distributions) of the plurality of selected cells MCi connected to the selected word line WLi corresponding to the selected address.

The memory system 1 causes the NAND memory 30 to execute distribution read for the selected word line WLi by the ICI correction circuit 18 of the memory controller 10 in order to sample the threshold voltage of the selected cell MCi.

The distribution read is an operation of measuring the distribution of the threshold voltages of the selected cells MCi connected to the selected word line WLi by measuring the number of the selected cells MCi in an ON state or the number of the selected cells MCi in an OFF state connected to the selected word line WLi while shifting the value of the voltage applied to the selected word line WLi by every predetermined voltage width.

In the distribution read, the distribution of the threshold voltage of the selected cell MCi is measured in each of a plurality of pages allocated to the selected word line WLi.

For example, in a case where the memory cell MC is the TLC, the threshold voltage distribution formed from the threshold voltages of the plurality of selected cells MCi of the selected word line WLi is measured for each of the lower page, the middle page, and the upper page with reference to the read level used for reading the corresponding page.

In the measurement of the threshold voltage distribution of the lower page, determination processing (reading) is executed a plurality of times for each of the AR reading (read level VAR) and the ER reading (read level VER).

In the AR reading, the threshold voltage distribution of the selected cell MCi is measured while the magnitude of the voltage (hereinafter also referred to as selected word line voltage) applied to the selected word line WLi is shifted to the low voltage side and the high voltage side within the range from the lower end of the threshold voltage distribution of the "Er" state T0 to the read level VBR with reference to the read level VAR. For example, for the AR reading, 31 times of determination processing are executed within the above voltage range while the voltage value of the word line voltage is shifted by 1 DAC or 2 DACs. The on and off states of the selected cell MCi are detected by each determination process.

The voltage VREAD is applied to the non-selected word lines other than the selected word line WLi.

Note that "DAC" corresponds to a set value (digital value) used to set a voltage value (analog value) of a charge pump that generates a voltage applied to the word line WL or the like in the NAND memory 30. For example, 1 DAC corresponds to 10 mV.

In the ER reading, the threshold voltage distribution of the selected cell MCi is measured while the magnitude of the selected word line voltage is shifted to the low voltage side and the high voltage side within the range from the read level VDR to the upper end of the threshold voltage distribution of the "G" state T7 with reference to the read level VER. For example, for the ER reading, 31 times of determination processing are executed within the above voltage range while the voltage value of the selected word line voltage is shifted by 1 DAC or 2 DACs.

Further, with respect to the distribution read of the lower page, CR reading (determination processing by the read level VCR) is executed once as level-separated reading (also referred to as single-state reading). The on and off states of the selected cell MCi are detected by the level-separated reading. By the level-separated reading of the CR reading, it is classified whether the state of the selected cell MCi is equal to or less than the "B" state T2 or equal to or more than the "C" state T3.

Thus, the measurement result of the threshold voltage distribution of the selected cell MCi in the lower page is obtained. Data related to the measurement result of the threshold voltage distribution of the selected cell MCi in the lower page is transferred from the NAND memory 30 to the memory controller 10. The memory controller 10 calculates the label value of each selected cell MCi in the lower page based on the data of the measurement result by the ICI correction circuit 18. Data of the label value (hereinafter referred to as label value data) of each selected cell MCi in the lower page is stored in the RAM 16 by the ICI correction circuit 18. The label value data is a set of label values of a plurality of selected cells MCi.

In the measurement of the threshold voltage distribution of the middle page, determination processing (reading) is executed a plurality of times for each of the BR reading (read level VBR), the DR reading (read level VDR), and the FR reading (read level VFR).

In the BR reading, the threshold voltage distribution of the selected cell MCi is measured while the magnitude of the selected word line voltage is shifted to the low voltage side and the high voltage side within the range from the lower end of the threshold voltage distribution of the "Er" state to the read level VCR with reference to the read level VBR. For example, for the BR reading, 31 times of determination processing are performed within the above voltage range while the voltage value of the selected word line voltage is shifted by 1 DAC or 2 DACs.

In the DR reading, the threshold voltage distribution of the selected cell MCi is measured while the magnitude of the selected word line voltage is shifted to the low voltage side and the high voltage side within the range from the read level VCR to the read level VER with reference to the read level VDR. For example, for the DR reading, 31 times of determination processing are executed within the above voltage range while the voltage value of the selected word line voltage is shifted by 1 DAC or 2 DACs.

In the FR reading, the threshold voltage distribution of the selected cell MCi is measured while the magnitude of the selected word line voltage is shifted to the low voltage side and the high voltage side within the range from the read level VER to the upper end of the threshold voltage distribution of the "G" state with reference to the read level VFR. For example, for the FR reading, 31 times of determination processing are executed within the above voltage range while the voltage value of the selected word line voltage is shifted by 1 DAC or 2 DACs.

Further, with respect to the distribution read of the middle page, the CR reading and the ER reading (determination processing based on the read level VER) are each executed once as level-separated reading. By the level-separated reading of the CR reading, it is classified whether the state of the selected cell MCi is equal to or less than the "B" state T2 or equal to or more than the "C" state T3. By the level-separated reading of the ER reading, it is classified whether the state of the selected cell MCi is equal to or less than the "D" state T4 or equal to or more than the "E" state T5.

Thus, the measurement result of the threshold voltage distribution of the selected cell MCi in the middle page is obtained. Data related to the measurement result of the threshold voltage distribution of the selected cell MCi in the middle page is transferred from the NAND memory 30 to the memory controller 10. The memory controller 10 calculates the label value of each selected cell MCi in the middle page based on the data of the measurement result by the ICI correction circuit 18. The label value data of each selected cell MCi in the middle page is stored in the RAM 16 by the ICI correction circuit 18.

In the measurement of the threshold voltage distribution of the upper page, determination processing (reading) is executed a plurality of times for each of CR reading (read level VCR) and GR reading (read level VGR).

In the CR reading, the threshold voltage distribution of the selected cell MCi is measured while the magnitude of the selected word line voltage is shifted to the low voltage side and the high voltage side within the range from the lower end of the threshold voltage distribution of the "Er" state to the read level VDR with reference to the read level VCR. For example, for the CR reading, 31 times of determination processing are executed within the above voltage range while the voltage value of the selected word line voltage is shifted by 1 DAC or 2 DACs.

In the GR reading, the threshold voltage distribution of the selected cell MCi is measured while the magnitude of the selected word line voltage is shifted to the low voltage side and the high voltage side within the range from the read level VER to the upper end of the threshold voltage distribution of the "G" state with reference to the read level VGR. For example, for the GR reading, 31 times of determination processing are executed within the above voltage range while the voltage value of the selected word line voltage is shifted by 1 DAC or 2 DACs.

Further, the ER reading is executed once as the level-separated reading for the distribution read of the upper page. By the level-separated reading of the ER reading, it is classified whether the state of the selected cell MCi is equal to or less than the "D" state T4 or equal to or more than the "E" state T5.

Thus, the measurement result of the threshold voltage distribution of the selected cell MCi in the upper page is obtained. Data related to the measurement result of the threshold voltage distribution of the selected cell MCi in the upper page is transferred from the NAND memory 30 to the memory controller 10. The memory controller 10 calculates the label value of each selected cell MCi in the upper page based on the data of the measurement result by the ICI correction circuit 18. The label value data of each selected cell MCi in the upper page is stored in the RAM 16 by the ICI correction circuit 18.

As described above, the number of times of reading in the middle page is larger than the number of times of reading in each of the lower page and the upper page. Therefore, the data size of the label value data related to the middle page is larger than the data size of the label value data related to the lower page and the data size of the label value data related to the upper page.

FIG. 8 is a schematic diagram illustrating a data storage state of the memory area 160 in the RAM 16 before and after execution of the distribution read.
(a) of FIG. 8 illustrates a data storage state of the memory area 160 before execution of the distribution read.
(b) of FIG. 8 illustrates a data storage state of the memory area 160 after execution of the distribution read.

In FIG. 8, the memory area 160 of the RAM 16 is an area secured for storing various data used for soft bit decoding reading. For example, the memory area 160 includes 10 data storage regions MEM (MEMO, MEM1, ..., MEM9).

As illustrated in (a) of FIG. 8, before execution of the distribution read, each of the data storage regions MEM of the memory area 160 is in a state of not storing data.

As illustrated in (b) of FIG. 8, after execution of the distribution read, the label value data DX1, DX2, and DX3 of the lower page, the middle page, and the upper page are stored in each of the data storage regions MEM of the memory area 160.

The label value data DX1, DX2, and DX3 of each page extend over a plurality of data storage regions MEM. Each of the label value data DX1, DX2, and DX3 is divided into a plurality of data units LBU<0>, ..., LBU<6> for each data storage region MEM.

Each of the data storage regions MEM0, ..., MEM5 stores the data units LBU<0>, ..., LBU<5> of the label value data DX1, DX2, and DX3 of the lower page, the middle page, and the upper page, respectively.

For example, the data unit LBU<0> of each page is stored in the data storage region MEM0. The data unit LBU<1> of each page is stored in the data storage region MEM1. The data unit LBU<2> of each page is stored in the data storage region MEM2. The data unit LBU<3> of each page is stored in the data storage region MEM3. The data unit LBU<4> of each page is stored in the data storage region MEM4. The data unit LBU<5> of each page is stored in the data storage region MEM5.

As described above, the data size of the label value data DX2 of the middle page is larger than the data size of the label value data DX1 of the lower page and the data size of the label value data DX3 of the upper page. Therefore, a data storage region MEM6 stores the data unit LBU<6> of the label value data DX2 of the middle page without storing the data units of the label value data DX1 and DX3 of the lower page and the upper data. For example, in the data storage region MEM6, "0" data is stored in a portion corresponding to the label value data DX1 and a portion corresponding to the label value data DX3.

A set of the data storage regions MEM0, ..., MEM6 corresponds to the first capacity of the storage capacity of the memory area 160. The first capacity is substantially equal to the data size of the read data (label value data) DX1, DX2, and DX3 by distribution read.

### <S12>

After execution of the distribution read, the memory system 1 determines, by the ICI correction circuit 18 of the memory controller 10, whether or not the selected word line WLi to be distributed read is the word line WL0 of the start end (first word line address).

If the selected word line WLi is the start word line WL0 (YES in S12), since there is no adjacent word line adjacent to the source side of the selected word line WLi (WL0), the memory system 1 executes processing of S15 described later.

### <S13>

If the selected word line WLi is not the word line WL0 at the start end (NO in S12), the memory system 1 causes the NAND memory 30 to execute the read operation for ICI cancellation correction (hereinafter referred to as ICI cancel read) on the adjacent word line WLi-1 adjacent to the selected word line WLi on the source side by the ICI correction circuit 18 of the memory controller 10.

The NAND memory 30 executes the read operation of hard bit decoding on all pages (here, the lower page, the middle page, and the upper page) of the adjacent word line WLi-1. Thus, read data for 3 pages is acquired for the adjacent word line WLi-1.

The read data of each page in the adjacent word line WLi-1 is transferred from the NAND memory 30 to the memory controller 10. The read data for the ICI cancellation correction is stored in the memory area 160 of the RAM 16.

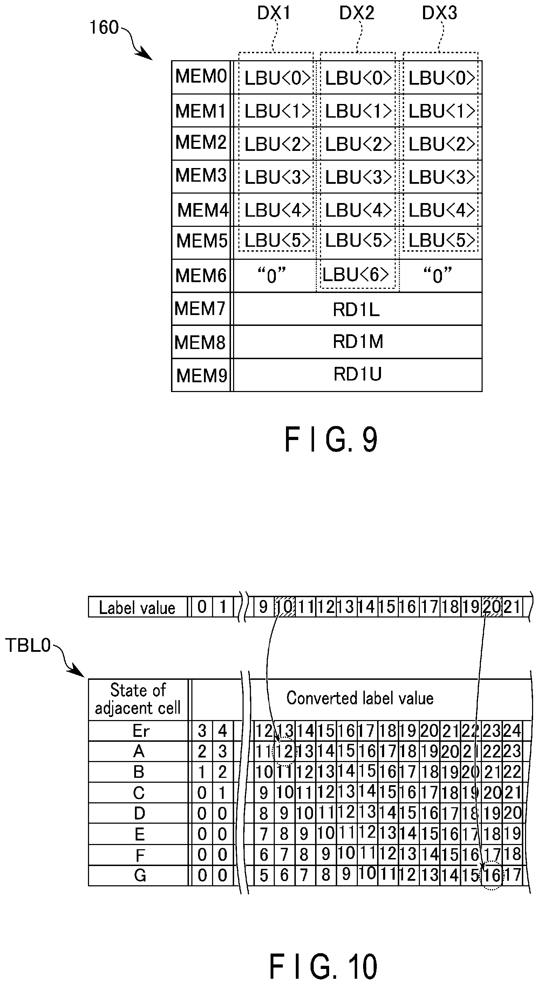

FIG. 9 is a schematic diagram illustrating a data storage state of the memory area 160 in the RAM 16 after execution of the ICI cancel read for the adjacent word line WLi-1.

As illustrated in FIG. 9, pieces of read data RD1L, RD1M, and RD1U for three pages from the adjacent word line WLi-1 are stored in the data storage region MEM of the memory area 160.

The read data RD1L of the lower page of the adjacent word line WLi-1 is stored in a data storage region MEM<7>. The read data RD1M of the middle page of the adjacent word line WLi-1 is stored in a data storage region MEM<8>. The read data RD1U of the upper page of the adjacent word line WLi-1 is stored in a data storage region MEM<9>.

The set of data storage regions MEM7, MEM8, and MEM9 corresponds to the second capacity excluding the first capacity of the set of data storage regions MEM0, ..., MEM6 in the storage capacity of the memory area 160. The second capacity is substantially equal to the data size (for example, the data size of data for three pages) of the read data RD1L, RD1M, and RD1U read from the adjacent word line WLi-1 (or the adjacent word line WLi+1) by the ICI cancel read.

### <S14>

After execution of the ICI cancellation read on the adjacent word line WLi-1, the memory system 1 executes the ICI cancellation correction for the result (label value data) of the distribution read for the selected word line WLi using the read data RD1L, RD1M, and RD1U from the adjacent word line WLi-1 acquired by the ICI cancellation read by the ICI correction circuit 18 of the memory controller 10.

The memory controller 10 determines the state of each adjacent cell MCi-1 of the adjacent word line WLi-1 using the read data RD1L, RD1M, and RD1U.

The memory controller 10 refers to the lookup table TBLO for ICI cancellation correction. The memory controller 10 accesses the memory area 160 of the RAM 16 and refers to data in the data storage region MEM.

The memory controller 10 converts the label value of each of the plurality of selected cells MCi connected to the selected word line WLi into a value obtained by correcting the interference of the adjacent cell MCi-1 based on the state (threshold voltage distribution) of the adjacent cell MCi-1 obtained from the read data RD1L, RD1M, and RD1U and the correction value of the lookup table TBLO. Thus, the label value of each selected cell MCi is corrected by the first ICI cancellation correction according to the read result with respect to the adjacent word line WLi-1.

FIG. 10 is a schematic diagram for describing the ICI cancellation correction using the lookup table TBLO.

As illustrated in FIG. 10, the lookup table TBLO is a table in which a plurality of converted label values corresponding to the states of the adjacent cells is arranged. The converted label value is a corrected label value of the selected cell that is preset based on the correspondence between the state of the adjacent cell and the label value.

If the label value of the selected cell MCi at a certain address (bit) of the selected word line WLi is "10" and the state of the adjacent cell at the corresponding address of the adjacent word line is the "A" state, the memory controller 10 raises the label value from "10" to "12" based on the lookup table TBLO. Thus, the corrected converted label value of the selected cell MCi is set to "12".

If the label value of the selected cell MC at a certain address of the selected word line WLi is "20" and the state of the adjacent cell at the corresponding address of the adjacent word line is the "G" state, the memory controller 10 lowers the label value from "20" to "16" based on the lookup table TBLO. Thus, the converted label value is set to "16".

In this manner, a plurality of label values included in the label value data DX1, DX2, and DX3 of each page is converted. Thus, first converted label value data DY1, DY2, and DY3 including the converted label values are acquired in the lower page, the middle page, and the upper page.

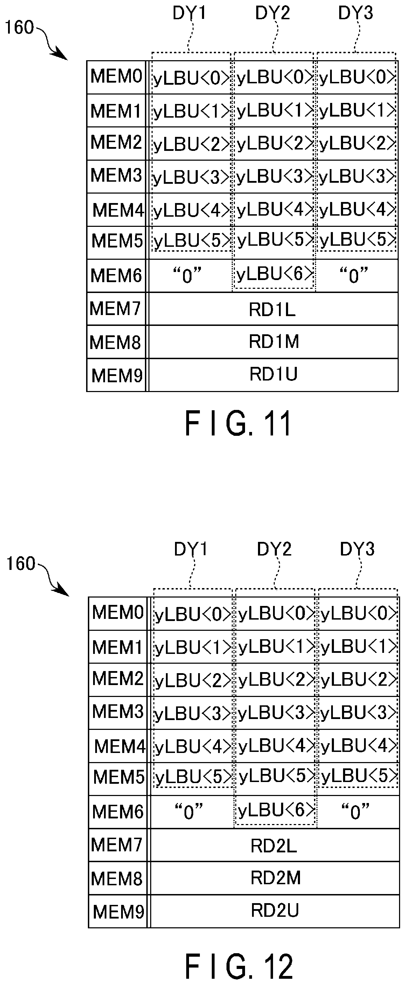

FIG. 11 is a schematic diagram illustrating a data storage state of the memory area 160 in the RAM 16 after the ICI cancellation correction based on the read result of the adjacent word line WLi-1.

As illustrated in FIG. 11, the stored data is updated in each of the data storage regions MEM0, **...,** MEM6.

The converted label value data DY1 of the lower page, the converted label value data DY2 of the middle page, and the converted label value data DY3 of the upper page are stored in the data storage regions MEM0, ..., MEM6. The converted label value data DY1, DY2, and DY3 include a plurality of data units yLBU including converted label values.

The data storage regions MEM7, MEM8, and MEM9 maintain the storage state of the read data RD1L, RD1M, and RD1U of the adjacent word line WLi-1.

### <S15>

In the memory system 1, the ICI correction circuit 18 of the memory controller 10 determines whether or not the selected word line WLi is the word line WLin-1 at the end (last word line address).

If the selected word line WLi is the word line WLn-1 at the end (YES in S15), since there is no adjacent word line adjacent to the drain side of the selected word line WLi (WLn-1), the memory system 1 executes processing of S18 described later.

### <S16>

If the selected word line WLi is not the word line WLn-1 at the end (NO in S15), the memory system 1 causes the NAND memory 30 to execute the read operation (ICI cancellation read) for ICI cancellation correction on the adjacent word line WLi+1 adjacent to the selected word line WLi on the drain side by the ICI correction circuit 18 of the memory controller 10.

The NAND memory 30 executes the read operation of hard bit decoding on all pages (here, the lower page, the middle page, and the upper page) of the adjacent word line WLi+1. Thus, read data for three pages is acquired for the adjacent word line WLi+1.

The read data of each page in the adjacent word line WLi+1 is transferred from the NAND memory 30 to the memory controller 10. The read data for the ICI cancellation correction is stored in the memory area 160 of the RAM 16.

FIG. 12 is a schematic diagram illustrating a data storage state of the memory area 160 in the RAM 16 after execution of the ICI cancellation read on the adjacent word line WLi+1 in a case where the selected word line WLi is not the end word line WLn-1.

As illustrated in FIG. 12, pieces of read data RD2L, RD2M, and RD2U of the adjacent word line WLi+1 are stored in the data storage region MEM of the memory area 160. For example, the memory controller 10 overwrites the read data RD2L, RD2M, and RD2U on the data storage regions MEM7, MEM8, and MEM9 storing the read data RD1L, RD1M, and RD1U. Thus, the memory controller 10 updates the data in the data storage regions MEM7, MEM8, and MEM9 to the read data RD2L, RD2M, and RD2U.

The read data RD2L of the lower page of the adjacent word line WLi+1 is stored in the data storage region MEM<7>. The read data RD2M of the middle page of the adjacent word line WLi+1 is stored in the data storage region MEM<8>. The read data RD2U of the middle page of the adjacent word line WLi+1 is stored in the data storage region MEM<9>.

The data storage regions MEM1, ..., MEM6 continue the storage state of the converted label value data DY1, DY2, and DY3.

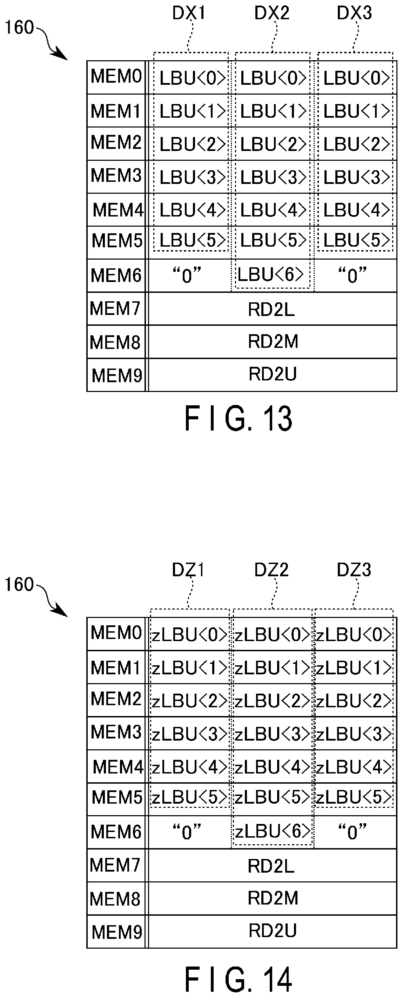

FIG. 13 is a schematic diagram illustrating a data storage state of the memory area 160 in the RAM 16 after execution of the ICI cancellation read on the adjacent word line WLi+1 in a case where the selected word line WLi is the start word line WL0.

In a case where the selected word line WLi is the start word line WL0, there is no adjacent word line WLi-1 on the source side. Therefore, as in the above-described S12, the ICI cancellation read and the ICI cancellation correction for the adjacent word line WLi-1 are skipped.

Therefore, in a case where the selected word line WLi is the start word line WL0, the read data of the adjacent word line WLi-1 is not acquired, and the label value is not converted (corrected) by the ICI cancellation correction.

As a result, as illustrated in FIG. 13, in a case where the selected word line WLi is the start word line WL0, the pieces of read data RD2L, RD2M, and RD2U from each page of the adjacent word line WLi+1 are stored in the data storage regions MEM7, MEM8, and MEM9 in a state where the pieces of unconverted label value data DX1, DX2, and DX3 are stored.

### <S17>

After execution of the ICI cancellation read on the adjacent word line WLi+1, the memory system 1 executes the ICI cancellation correction on the converted label value data DY1, DY2, and DY3 (alternatively, the label value data DX1, DX2, and DX3 before correction) by the ICI correction circuit 18 of the memory controller 10 using the read data RD2L, RD2M, and RD2U from the adjacent word line WLi+1 acquired by the ICI cancellation read.

The memory controller 10 determines the state of each adjacent cell MCi+1 of the adjacent word line WLi+1 using the read data RD2L, RD2M, and RD2U.

The memory controller 10 refers to the lookup table TBLO for ICI cancellation correction. The memory controller 10 accesses the memory area 160 of the RAM 16 and refers to data in the data storage region MEM.

The memory controller 10 converts the label value of each of the plurality of selected cells MCi connected to the selected word line WLi based on the state (threshold voltage distribution) of the adjacent cell MCi+1 obtained from the read data RD2L, RD2M, and RD2U and the correction value of the lookup table TBLO. Thus, the label value of the selected cell MCi is corrected by the second (or first) ICI cancellation correction according to the read result for the adjacent word line WLi+1.

In a case where the ICI cancellation correction with the read data RD1L, RD1M, and RD1U of the adjacent word line WLi-1 on the source side is executed, the converted label value data DY1, DY2, and DY3 are corrected again by the read data RD2L, RD2M, and RD2U of the adjacent word line WLi+1 on the drain side.

The memory system 1 converts the converted label value of the data unit yLBU of each piece of the label value data DY1, DY2, and DY3 again, as in the processing of S14 and FIG. 10 described above.

FIG. 14 is a schematic diagram illustrating a data storage state of the memory area 160 in the RAM 16 after the ICI cancellation correction based on the read result of the adjacent word line WLi+1.

FIG. 14 illustrates the data storage state of the memory area 160 after the ICI cancellation correction performed twice in a case where the selected word line WLi is not the start word line WL0 and the end word line WLn-1 (in a case where the selected word line WLi is an intermediate word line).

As illustrated in FIG. 14, the stored data is updated in each of the data storage regions MEM0, ..., MEM6.

Second converted label value data DZ1 of the lower page, second converted label value data DZ2 of the middle page, and second converted label value data DZ3 of the upper page are stored in the data storage regions MEM0, ..., MEM6. The converted label value data DZ1, DZ2, and DZ3 include a plurality of data units zLBU including converted label values reflecting the states of both of the two adjacent word lines WLi-1 and WLi+1.

The data storage regions MEM7, MEM8, and MEM9 continue the storage state of the read data RD2L, RD2M, and RD2U of the adjacent word line WLi+1.

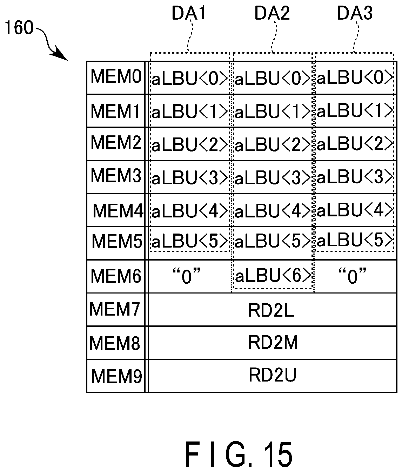

Note that FIG. 15 illustrates the data storage state of the memory area 160 of the RAM 16 after the ICI cancellation correction based on the read result of the adjacent word line WLi+1 in a case where the selected word line WLi is the start word line WL0.

As described above, if the selected word line WLi is the start word line WL0, since the ICI cancellation read and the ICI cancellation correction based on the read result of the source-side adjacent word line WLi-1 are not executed, the label value is converted into the converted label value by one conversion processing based on the read data RD2L, RD2M, and RD2U from the adjacent word line WLi+1. Thus, pieces of converted label value data DA1, DA2, and DA3 of each page of the selected word line WLi by correcting only the read result of the adjacent word line WLi+1 are generated and stored in the memory area 160. The pieces of converted label value data DA1, DA2, and DA3 include a plurality of data units aLBU including converted label values reflecting only the influence of the state of the adjacent cell MCi+1 of the adjacent word line WLi+1.

Note that, if the selected word line WLi is the end word line, the processing of S16 and S17 is not executed, and thus the memory system 1 executes the processing of S18 in a state where the memory area 160 continues the data storage state illustrated in FIG. 11.

### <S18>

In the memory system 1, the ECC circuit 14 or the ICI correction circuit 18 of the memory controller 10 generates read data (hereinafter also referred to as soft bit read data) by soft bit decoding processing on the converted label value data corrected by the ICI cancellation correction performed twice (or once). For example, the read data is full soft bit (FSB) read data.

Note that the generation of the read data by the soft bit decoding processing may include various types of processing including tracking process and/or update (generation) of various tables based on the results of the distribution read and the ICI cancel read.

The memory system 1 transfers the generated read data to the host 2.

As described above, the read operation of soft bit decoding of the memory system 1 of the present embodiment is completed.

Note that, after the ICI cancellation read and the ICI cancellation correction of the adjacent word line WLi+1 adjacent to the selected word line WLi on the drain side of the NAND string NS are executed, the ICI cancellation read and the ICI cancellation correction of the adjacent word line WLi-1 adjacent to the selected word line WLi on the source side of the NAND string NS may be executed.

### (c) Summary

In a general memory system, at the time of generating read data by soft bit decoding, various kinds of data for generating read data of soft bit decoding are temporarily stored in a RAM.

In order to generate read data having high reliability, not only the information from the memory cell of the selected word line to be read but also the information from the memory cell of the word line adjacent to the selected word line is used. As a result, the amount of information stored in the RAM tends to increase during the read operation of soft bit decoding.

Further, in order to generate read data of soft bit decoding with high reliability, it is desirable to use a lookup table with a large data size. However, due to an increase in the data size of the lookup table, the storage capacity of the memory area reserved in the RAM for storing the lookup table increases.

An increase in the storage capacity of the RAM may be undesirable from the viewpoint of reducing the specifications of the memory system and the cost of the memory system.

In the general memory system, in order to generate read data by soft bit decoding, read data from one or two adjacent word lines adjacent to the selected word line is acquired. Considering the effects of ICI from two adjacent word lines, it is preferable to correct the data from the selected word line by the read data from the two adjacent word lines in order to generate highly reliable read data.

As the data size of page data increases, it may be difficult to simultaneously store both read data from each of two adjacent word lines in a memory area having a small storage capacity during the read operation of soft bit decoding.

Therefore, the general memory system corrects data from a selected word line based on a correction value obtained by combining read data from two adjacent word lines. For example, in a case where the memory cell is the TLC, eight correction patterns are generated by combining read data from two adjacent word lines. The threshold voltage (label value) of the selected cell is corrected with a correction value corresponding to the eight correction patterns. Therefore, in the general memory system, there is a possibility that reliability of read data of soft bit decoding is lowered.

If read data is obtained from both of the two adjacent word lines WLi-1 and WLi+1, the memory system 1 of the present embodiment corrects the label value (threshold voltage) of the selected cell MCi of the selected word line WLi for each piece of read data of the adjacent word lines WLi-1 and WLi+1. Therefore, in the present embodiment, the label value of the selected cell MCi is corrected twice.

Thus, the memory system 1 of the present embodiment can correct the label value of the selected cell MCi in consideration of the patterns of the eight states (threshold voltages) that can be taken by the adjacent cell MCi-1 of the adjacent word line WLi-1 and the patterns of the eight states that can be taken by the adjacent cell MCi+1 of the adjacent word line WLi-1.

That is, in a case where the memory cell MC is the TLC, 64 correction patterns that can be taken by the combination of the state of the adjacent cell of the adjacent word line WLi-1 and the state of the adjacent cell of the adjacent word line WLi+1 are reflected in the label value of each selected cell MCi of the selected word line WLi. As described above, the memory system 1 of the present embodiment can correct the label value of the selected cell MCi with a more suitable correction value.

As a result, the memory system 1 of the present embodiment can generate highly accurate read data by soft bit decoding.

As described above, the memory system 1 of the present embodiment can improve the reliability of data reading.

### (2) Second Embodiment

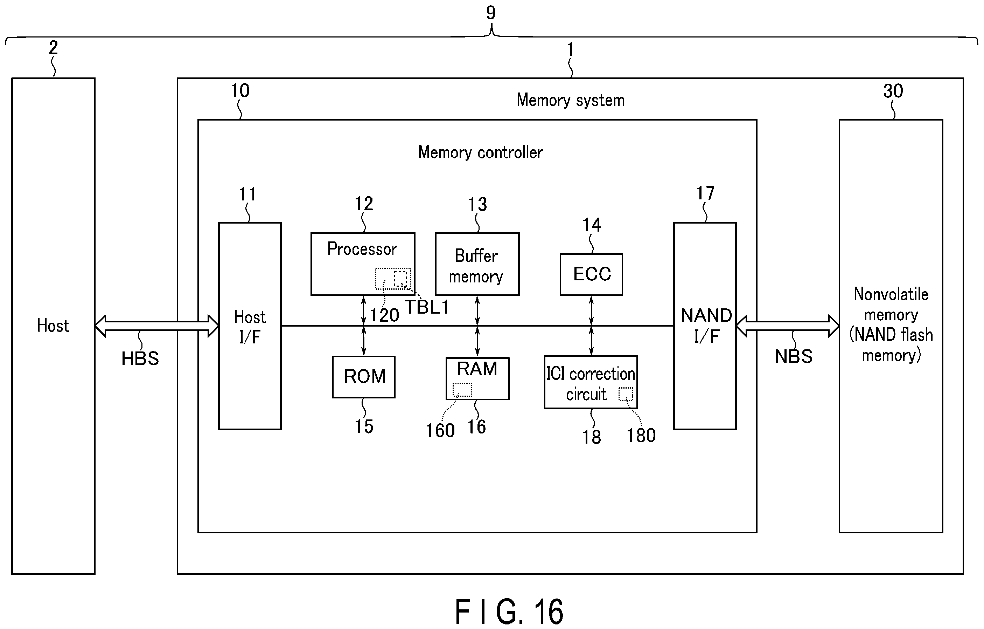

A memory system and a method of controlling the memory system of the second embodiment will be described with reference to FIGS. 16 to 23.

### (a) Configuration Example

FIG. 16 is a block diagram for describing a configuration example of the memory system of the present embodiment.

As illustrated in FIG. 16, the memory system 1 of the present embodiment includes a histogram engine (also referred to as a histogram generation circuit) 180. The histogram engine 180 is provided, for example, in the ICI correction circuit 18. Note that the histogram engine 180 may be a circuit independent of the ICI correction circuit 18 or a functional block of the processor 12.

The histogram engine 180 generates a histogram based on results of the distribution read and the ICI cancel read. In the present embodiment, the histogram indicates a distribution of the number of memory cells (hereinafter referred to as the number of section cells) turned on in a voltage section divided for each selected word line voltage at the time of distribution read with respect to each state of the adjacent cells. The voltage section of the selected word line voltage is associated with the label value of the memory cell MC.

The processor 12 holds a table including correction values (hereinafter referred to as a correction value table) TBL1 (TBL1a, TBL1b) obtained based on the histogram. For example, the correction value table TBL1 is stored in firmware 120 of the processor 12. Note that the firmware 120 and the correction value table TBL1 may be provided in the RAM 16.

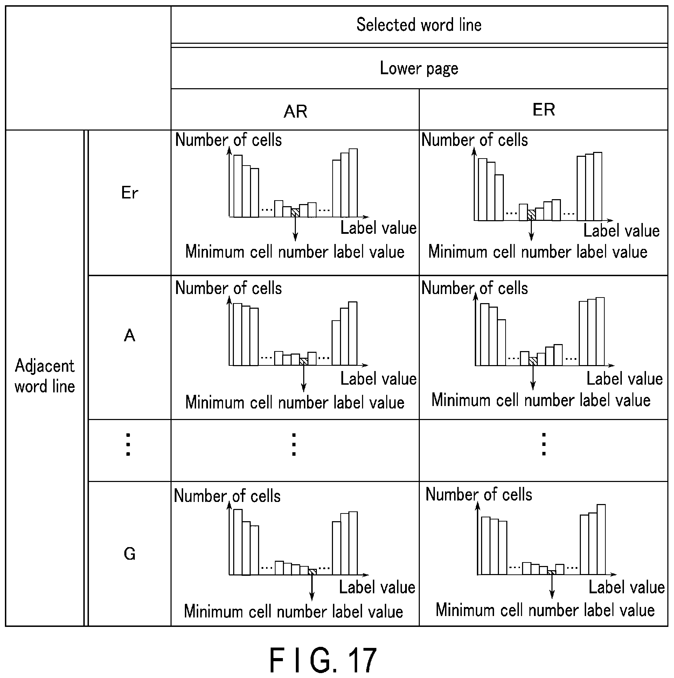

FIG. 17 is a schematic diagram for describing a histogram for a state of an adjacent cell and the number of section cells in the memory system 1 of the present embodiment.

FIG. 17 illustrates an example of a histogram generated based on reading results of the lower page.

As described above, in the memory system 1, in reading of the lower page in the distribution read, the voltage is shifted with reference to the read level VAR of the AR read, and the number of memory cells in an ON state in each voltage section of the selected word line is counted. Thus, the number of section cells in each voltage section is acquired with respect to the read level VAR. Further, in the reading of the lower page in the distribution read, the number of memory cells in an ON state in each voltage section is counted while the voltage is shifted with reference to the read level VER of the ER reading. Thus, the number of section cells in each voltage section is acquired with respect to the read level VER.

As illustrated in FIG. 17, the memory system 1 generates a histogram for the number of section cells of the selected cell MCi for each state of the adjacent cells MCi-1 and MCi+1 in each of the adjacent word lines WLi-1 and WLi+1 based on the result of the ICI cancellation read by the histogram engine 180 of the memory controller 10.

The memory system 1 acquires a label value (hereinafter referred to as minimum cell number label value) corresponding to the minimum number of section cells in the histogram for each state of the adjacent cell based on the generated histogram.

A correction value for ICI cancellation is calculated by a calculation process (for example, a difference process) on the acquired minimum cell number label value and a label value of a reference state (for example, the "Er" state). The correction value table TBL1 including the calculated correction value is stored in the firmware 120 of the processor 12.

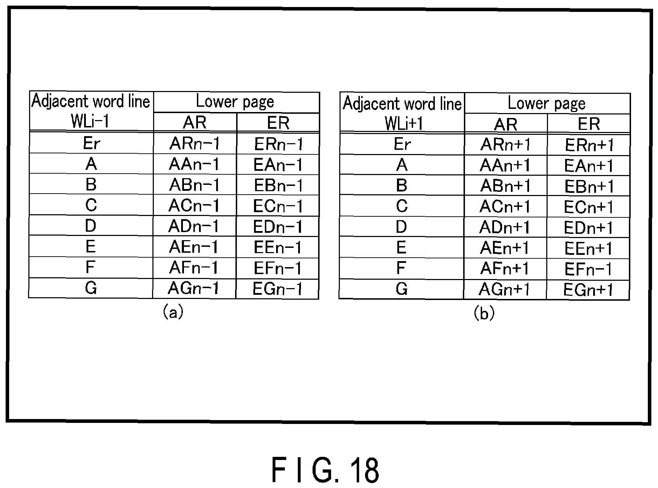

FIG. 18 is a diagram illustrating an example of the minimum cell number label value obtained by the processing using the histogram. In FIG. 18, the minimum cell number label value regarding the read result of the lower page acquired by the histogram is illustrated. In (a) of FIG. 18, the minimum cell number label value of the selected cell MCi of the AR reading for the state of the adjacent cell MCi-1 and the minimum cell number label value of the selected cell MCi of the ER reading for the state of the adjacent cell MCi-1 in the source-side adjacent word line WLi-1 are illustrated. Further, in (b) of FIG. 18, the minimum cell number label value of the selected cell MCi of the AR reading for the state of the adjacent cell MCi+1 and the minimum cell number label value of the selected cell MCi of the ER reading for the state of the adjacent cell MCi+1 in the drain-side adjacent word line WLi+1 are illustrated.

As illustrated in (a) of FIG. 18, regarding the adjacent word line WLi-1, in each of the AR reading and the ER reading of the lower page, the minimum cell number label values ARn-1, AAn-1, ..., AFn-1, AGn-1, ERn-1, EAn-1, ..., EFn-1, and EGn-1 of the selected cell MCi according to the state of the adjacent cell MCi-1 are acquired.

Similarly, as illustrated in (b) of FIG. 18, regarding the adjacent word line WLi+1, in each of the AR reading and the ER reading of the lower page, the minimum cell number label values ARn+1, AAn+1, ..., AFn+1, AGn+1, ERn+1, EAn+1, ..., EFn+1, and EGn+1 of the selected cells according to the state of the adjacent cell MCi+1 are acquired.

For example, the minimum cell number label values ARn-1, ARn+1, ERn-1, and ERn+1 in a case where the adjacent cells MCi-1 and MCi+1 are in the "Er" state is set to a label value as a reference (hereinafter referred to as reference label value) for calculating correction values.

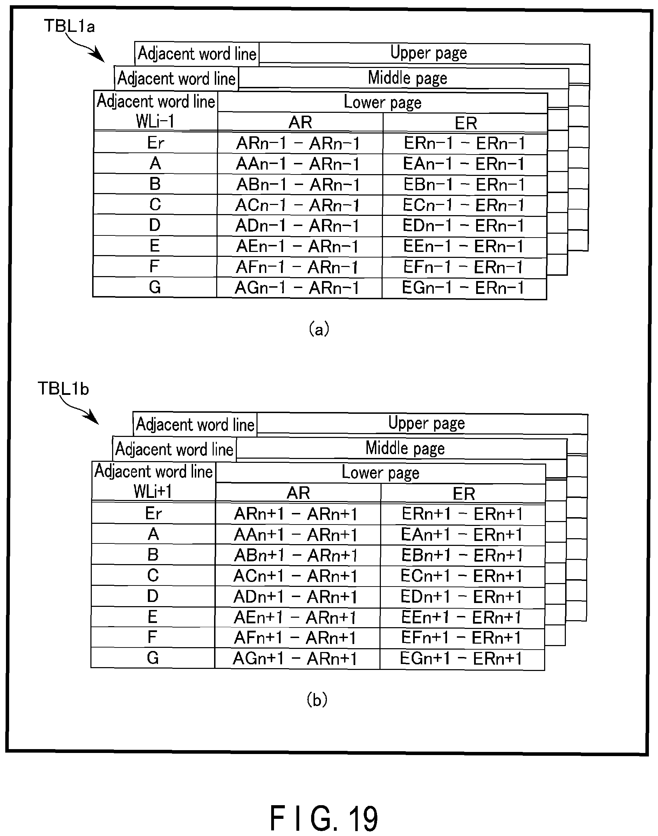

FIG. 19 is a schematic diagram illustrating an example of correction values obtained by the processing using the histogram. In FIG. 19, regarding the lower page, an example of correction values according to the states of the adjacent cells MCi-1 and MCi+1 of the adjacent word lines WLi-1 and WLi+1 is illustrated. In (a) of FIG. 19, correction values of the AR reading for the state of the adjacent cell MCi-1 and correction values of the ER reading for the state of the adjacent cell MCi-1 in the source-side adjacent word line WLi-1 are illustrated. Further, in (b) of FIG. 19, correction values of the AR reading for the state of the adjacent cell MCi+1 and correction values of the ER reading for the state of the adjacent cell MCi+1 in the drain-side adjacent word line WLi+1 are illustrated.

As illustrated in (a) and (b) of FIG. 19, a value of a difference between the minimum cell number label value and the reference label value is set as the correction value.

For example, as in the correction value table TBL1a of the source-side adjacent word line WLi-1 illustrated in (a) of FIG. 19, in the selected cell MCi in the "A" state, if the adjacent cell MCi-1 is in the "Er" state, the minimum cell number label value is "ARn-1" and the reference label value is "ARn-1". In this case, the correction value is "ARn-1" - "ARn-1".

Further, as in the correction value table TBL1b of the drain-side adjacent word line WLi+1 illustrated in (b) of FIG. 19, in the selected cell MCi in the "E" state, if the adjacent cell MCi+1 is in the "B" state, the minimum cell number label value is "EBn+1" and the reference label value is "ERn+1". In this case, the correction value is "EBn+1" - "ERn+1".

In this manner, the correction value table TBL1 (TBL1a, TBL1b) of the lower page is generated.

For example, the memory system 1 generates a correction value table TBL1a for the source-side adjacent word line WLi-1 and a correction value table TBL1b for the drain-side adjacent word line WLi+1.

Note that, as for the middle page and the upper page, as in the examples illustrated in FIGS. 17 and 18, a histogram is generated for each of the adjacent word lines WLi-1 and WLi+1, and the minimum cell number label value is acquired based on the generated histogram. Similarly to the example illustrated in FIG. 19, correction values of the label value of the selected cell MCi according to the states of the adjacent cells MCi-1 and MCi+1 in the middle page and the upper page are calculated based on the acquired minimum cell number label value. The correction value table TBL1 (TBL1a, TBL1b) of the middle page and the upper page is generated based on the calculated correction value.

The memory system 1 of the present embodiment dynamically calculates correction values based on results of read operations for the selected word line WLi and the adjacent word lines WLi-1 and WLi+1 without using the lookup table including correction values calculated in advance.

Thus, the memory system 1 of the present embodiment can further improve the accuracy of the ICI cancellation correction.

### (b) Operation Example

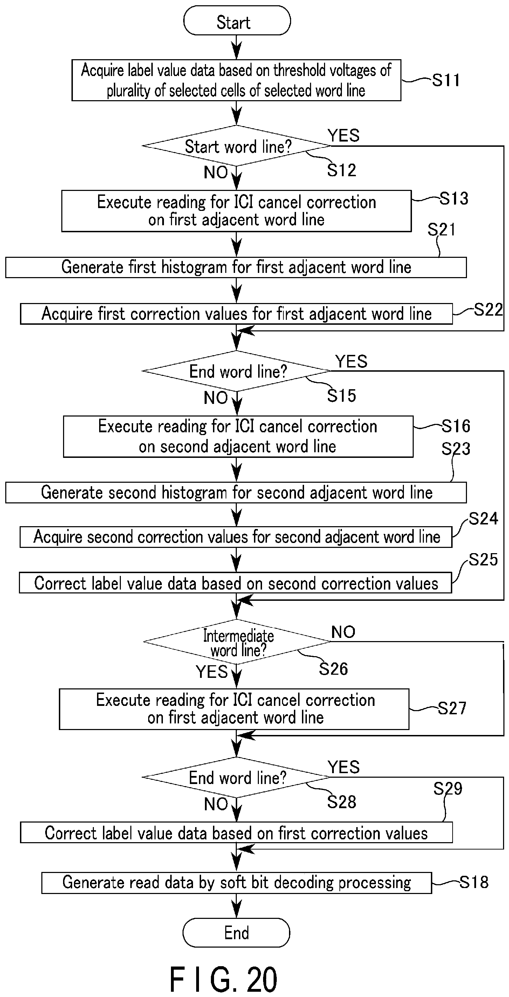

An operation example (a method of controlling the memory system 1) of the memory system 1 of the present embodiment will be described with reference to FIGS. 20 to 23.

FIG. 20 is a flowchart illustrating an operation example of the memory system 1 of the present embodiment.

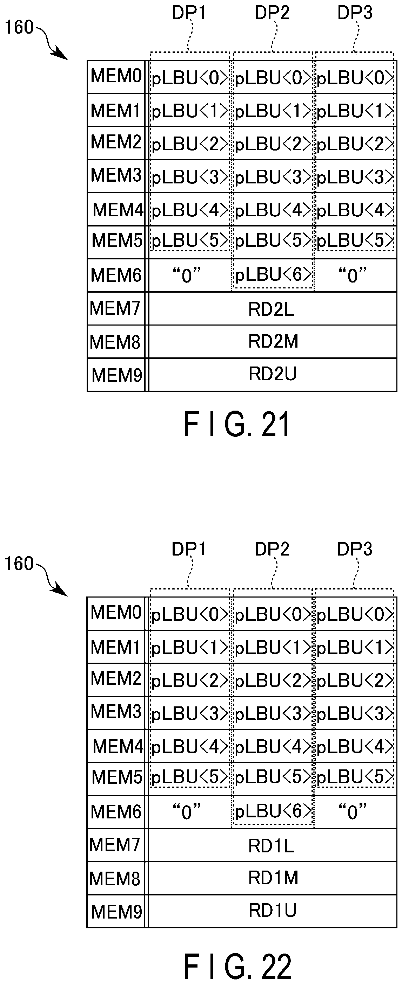

FIGS. 21 to 23 are schematic diagrams for describing the operation example of the memory system 1 of the present embodiment.

### <S11, S12, and S13>

As illustrated in FIG. 20, after execution of the distribution read on the selected word line WLi, if the selected word line WLi is not the start word line WL0 (NO in S12), the memory system 1 of the present embodiment executes the read operation of hard bit decoding (ICI cancel read) on all pages of the adjacent word line WLi-1 on the source side.

Data acquired by the distribution read and the ICI cancel read on the adjacent word line WLi-1 is stored in the memory area 160 of the RAM 16 as illustrated in FIG. 9 described above.

Note that, if the selected word line WLi is the start word line WL0, the memory system 1 executes the distribution read and then executes the processing of S15.

### <S21>

The memory system 1 uses the read data (label value data) DX1, DX2, and DX3 of the distribution read and the read data RD1L, RD1M, and RD1U of the ICI cancel read by the histogram engine 180 of the memory controller 10 to generate a histogram (first histogram) for the state of the adjacent cell MCi-1 of the adjacent word line WLi-1 and the number of section cells as illustrated in FIG. 17.

### <S22>

The memory system 1 acquires the minimum cell number label value and the reference label value in the adjacent word line WLi-1 based on the generated histogram for the adjacent word line WL-1 as illustrated in FIG. 18. As illustrated in FIG. 19, the memory system 1 acquires a plurality of correction values according to the relationship between the state (read result) of the selected cell MCi and the state of the adjacent cell MCi-1 of the adjacent word line WLi-1 for each state of the memory cell MC by the calculation processing (for example, differential processing) of the acquired minimum cell number label value and the reference label value.

The memory system 1 stores the correction value for the adjacent word line WLi-1 in the firmware 120 of the processor 12. Thus, the correction value table TBL1 is stored in the firmware 120.

### <S15 and S16>

If the selected word line WLi is not the end word line WLn-1 (NO in S15), the memory system 1 executes the read operation of hard bit decoding (ICI cancel read) on all the pages of the adjacent word line WLi+1 on the drain side. The read data from all the pages of the adjacent word line WLi+1 is stored in the memory area 160 of the RAM 16 as illustrated in FIG. 13 described above. Therefore, the read data from the adjacent word line WLi-1 is erased from the memory area 160.

### <S23>

The memory system 1 uses the read data DX1, DX2, and DX3 of the distribution read and the read data RD2L, RD2M, and RD2U of the ICI cancellation read on the adjacent word line WLi+1 by the histogram engine 180 of the memory controller 10 to generate a histogram (second histogram) for the state of the adjacent cell MCi+1 of the adjacent word line WLi+1 and the number of section cells as illustrated in FIG. 17.

### <S24>

As illustrated in FIG. 18, the memory system 1 acquires the minimum cell number label value and the reference label value in the adjacent word line WLi+1 based on the generated histogram for the adjacent word line WLi+1 by the ICI correction circuit 18 of the memory controller 10. As illustrated in FIG. 19, the memory system 1 acquires a plurality of correction values according to the relationship between the state of the selected cell MCi and the state of the adjacent cell MCi+1 of the adjacent word line WLi+1 for each state of the memory cell MC by the calculation processing (difference processing) of the acquired minimum cell number label value and the reference label value.

The memory system 1 stores the correction value for the adjacent word line WLi+1 in the firmware 120 of the processor 12. Thus, the correction value table TBL1 is stored in the firmware 120.

### <S25>

The memory system 1 executes the ICI cancellation correction on the read data (label value data) of the selected cell MCi obtained by the distribution read based on the correction values of the correction value table TBL1 and the read data RD2L, RD2M, and RD2M of the adjacent word line WLi+1 by the ICI correction circuit 18 of the memory controller 10. Thus, the label value of each selected cell MCi obtained by the distribution read is corrected.

FIG. 21 illustrates a data storage state of the memory area 160 of the RAM 16 after the ICI cancellation correction according to the state of the adjacent cell MCi+1 of the adjacent word line WLi+1.

As illustrated in FIG. 21, the corrected label value data DP1, DP2, and DP3 are stored in the memory area 160. The label values in the data storage regions MEM0, ... MEM6 of the memory area 160 are converted into corrected label values based on the correction values obtained from the histograms for the adjacent word lines WLi+1. Thus, data units pLBU after the correction in the converted label value data DP1, DP2, and DP3 are stored in the data storage regions MEM0, ... MEM6.

Thereafter, the read data from the erased adjacent word line WLi-1 is read again.

### <S26>

The memory system 1 determines whether or not the selected word line WLi is an intermediate word line. If the selected word line WLi is not the intermediate word line (NO in S26), the memory system 1 executes the processing of S28 described later.

### <S27>

If the selected word line WLi is the intermediate word line (YES in S26), the memory system 1 executes the ICI cancellation read on all pages of the adjacent word line WLi-1 substantially as in the processing of S13. Read data from all pages of the adjacent word line WLi-1 is stored in the memory area 160.

FIG. 22 illustrates a data storage state of the memory area 160 of the RAM 16 after the ICI cancellation read on the adjacent word line WLi-1.

As illustrated in FIG. 22, the pieces of read data RD1L, RD1M, and RD1U from the adjacent word line WLi-1 are stored in the data storage regions MEM7, MEM8, and MEM9 of the memory area 160. The read data from the adjacent word line WLi+1 is erased from the memory area 160.

Note that, in a case where the ICI cancellation correction for the adjacent word line WLi+1 is executed, the pieces of corrected label value data DP1, DP2, and DP3 are stored in the data storage regions MEM0, ... MEM6.

### <S28>

After the second ICI cancellation read on the adjacent word line WLi-1, the memory system 1 determines whether or not the selected word line WLi is the start word line WL0 by the ICI correction circuit 18 of the memory controller 10.

If the selected word line WLi is the start word line WL0 (YES in S28), the memory system 1 executes the processing of S18.

### <S29>

If the selected word line WLi is not the start word line WL0 (NO in S28), the memory system 1 executes the ICI cancellation correction on the read data (corrected label value data or original label value data) of the selected cell MCi based on the correction value of the correction value table TBL1 and the reacquired read data RD1L, RD1M, and RD1U of the adjacent word line WLi-1 by the ICI correction circuit 18 of the memory controller 10. Accordingly, the label value of each selected cell MCi is corrected.

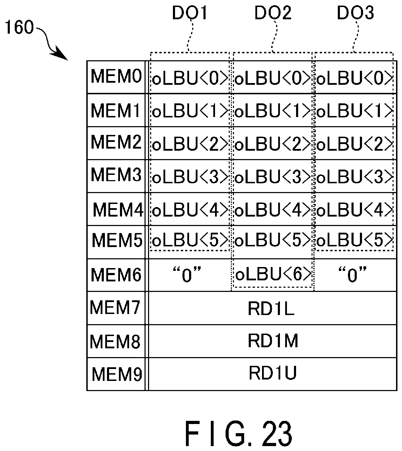

FIG. 23 illustrates a data storage state of the memory area 160 of the RAM 16 after the ICI cancellation correction according to the state of the adjacent cell MCi-1 of the adjacent word line WLi-1.

As illustrated in FIG. 23, the corrected label value data DO1, DO2, and DO3 are stored in the memory area 160. The label values in the data storage regions MEM0, ... MEM6 of the memory area 160 are converted into corrected label values based on the correction values obtained from the histograms for the adjacent word lines WLi-1. Thus, corrected data units oLBU in the converted label value data DO1, DO2, and DO3 are stored in the data storage regions MEMO, ... MEM6.

For example, in the label values of the plurality of data units oLBU of the data DO1, DO2, and DO3, both the correction value according to the state of the adjacent cell MCi+1 of the adjacent word line WLi+1 and the correction value according to the state of the adjacent cell MCi-1 of the adjacent word line WLi-1 are reflected.

### <S18>

In the memory system 1, the ECC circuit 14 or the ICI correction circuit 18 of the memory controller 10 generates soft bit read data by soft bit decoding processing on the converted label value data corrected by the ICI cancellation correction of one or both of the adjacent word lines WLi-1 and WLi+1.

The memory controller 10 transfers the generated soft bit read data to the host 2.

As described above, the read operation of soft bit decoding of the memory system 1 of the present embodiment is completed.

### (c) Summary

The memory system 1 of the present embodiment dynamically calculates correction values based on results of read operations without using a lookup table including correction values calculated in advance.

Thus, the memory system 1 of the present embodiment can further improve the accuracy of the ICI cancellation correction.

Therefore, the memory system 1 of the present embodiment can improve the reliability of data reading.

### (4) Others

In the memory system of the embodiment, the memory device 30 may be a memory device other than the NAND flash memory. For example, the memory device 30 may be a volatile memory such as a DRAM.
Various embodiments are in accordance with the following numbered clauses.
Clause 1. A memory system (1) comprising:
   a memory device (30) including a plurality of word lines and a plurality of memory cells (MCO to MCn-1) connected to each of the plurality of word lines (WLO to WLn-1); and
   a memory controller (10) that controls a read operation of the memory device, wherein
   the memory controller is configured to:
      acquire first data (DX1, DX2, DX3) related to threshold voltages of a plurality of selected cells connected to a selected word line among the plurality of word lines,
      acquire second data (RD1L, RD1M, RD1U) from a plurality of first adjacent cells connected to a first adjacent word line adjacent to one end of the selected word line among the plurality of word lines,
      acquire first correction data (DY1, DY2, DY3) by correcting the first data based on the second data,
      acquire third data (RD2L, RD2M, RD2U) from a plurality of second adjacent cells connected to a second adjacent word line adjacent to another end of the selected word line among the plurality of word lines,
      acquire second correction data (DZ1, DZ2, DZ3) by correcting the first correction data based on the third data, and
      execute soft bit decoding processing on the second correction data to generate read data from the plurality of selected cells.
Clause 2. The memory system according to clause 1, wherein
   the memory controller includes a memory area, and
   the memory controller is configured to:
      store the first data in a first storage region of the memory area,
      store the second data in a second storage region of the memory area, and
      updates the second data in the second storage region to the third data, and stores the third data in the second storage region.
Clause 3. The memory system according to clause 2, wherein
   the memory controller is configured to:
   update the first data in the first storage region to the first correction data, and stores the first correction data in the first storage region, and
   update the first correction data in the first storage region to the second correction data, and stores the second correction data in the first storage region.
Clause 4. A memory system (1) comprising:
   a memory device (30) including a plurality of word lines (WLO to WLn-1) and a plurality of memory cells (MCO to MCn-1) connected to each of the plurality of word lines; and
   a memory controller (10) including a memory area (160) that stores data acquired from the plurality of memory cells, wherein
   the memory controller is configured to:
      store first data (DX1, DX2, DX3) related to threshold voltages of a plurality of selected cells connected to a selected word line among the plurality of word lines in a first storage region of the memory area,
      store, in a second storage region of the memory area, second data (RD1L, RD1M, RD1U) acquired from a plurality of first adjacent cells connected to a first adjacent word line adjacent to one end of the selected word line among the plurality of word lines,
      generate first correction data (DY1, DY2, DY3) by correcting the first data based on the second data,
      store the first correction data in the first storage region,
      store, in the second storage region, third data (RD2L, RD2M, RD2U) acquired from a plurality of second adjacent cells connected to a second adjacent word line adjacent to another end of the selected word line among the plurality of word lines,
      generate second correction data (DZ1, DZ2, DZ3) by correcting the first correction data based on the third data,
      store the second correction data in the first storage region, and
      execute soft bit decoding processing on the second correction data to generate read data from the plurality of selected cells.
Clause 5. The memory system according to any of clauses 1 to 4, wherein
   the first data includes a plurality of label values corresponding to a threshold voltage of each of the plurality of selected cells, and the memory controller includes a first table indicating a relationship between a threshold voltage state of each of the plurality of first and second adjacent cells and a corrected label value, and
   the memory controller is configured to correct the plurality of label values according to the threshold voltage state of each of the plurality of first and second adjacent cells based on the first table.
Clause 6. The memory system according to any of clauses 1 to 5, wherein
   the memory controller is configured to:
   generate a first histogram indicating a relationship between a threshold voltage state of each of the plurality of first adjacent cells and a plurality of label values according to the threshold voltages of the plurality of selected cells,
   calculate a plurality of first correction values according to the threshold voltage state of each of the plurality of first adjacent cells based on the first histogram,
   generate a second histogram indicating a relationship between a threshold voltage state of each of the plurality of second adjacent cells and the plurality of label values according to the threshold voltages of the plurality of selected cells,
   calculate a plurality of second correction values according to the threshold voltage state of each of the plurality of second adjacent cells based on the second histogram, and
   correct each of the label values based on the plurality of first and second correction values.
Clause 7. The memory system according to clause 6, wherein
   the memory controller is configured to generate a second table related to the plurality of first and second correction values based on the first and second histograms.
Clause 8. The memory system according to clause 7, wherein
   the memory controller includes firmware that stores the second table.
Clause 9. The memory system according to any of clauses 1 to 8, wherein
   the memory controller is configured to:
   determine a threshold voltage state of each of the plurality of first adjacent cells based on the second data,
   correct the first data according to the threshold voltage state of each of the plurality of first adjacent cells,
   determine a threshold voltage state of each of the plurality of second adjacent cells based on the third data, and
   correct the first correction data according to the threshold voltage state of each of the plurality of second adjacent cells.
Clause 10. The memory system according to any of clauses 1 to 9, wherein
   the memory controller is configured to correct an error in the first data caused by a shift of the threshold voltages of the plurality of selected cells in response to at least one of interference between the plurality of selected cells and the plurality of first adjacent cells or interference between the plurality of selected cells and the plurality of second adjacent cells.
Clause 11. A method of controlling a memory system (1), the method comprising:
   acquiring first data (DX1, DX2, DX3) related to a threshold voltage of a plurality of selected cells (MCO to MCn-1) connected to a selected word line among a plurality of word lines (WLO to WLn-1),
   acquiring second data (RD1L, RD1M, RD1U) from a plurality of first adjacent cells connected to a first adjacent word line adjacent to one end of the selected word line among the plurality of word lines,
   acquiring first correction data (DY1, DY2, DY3) by correcting the first data based on the second data,
   acquiring third data(RD2L, RD2M, RD2U) from a plurality of second adjacent cells connected to a second adjacent word line adjacent to another end of the selected word line among the plurality of word lines,
   acquiring second correction data (DZ1, DZ2, DZ3) by correcting the first correction data based on the third data, and
   executing soft bit decoding processing on the second correction data to generate read data from the plurality of selected cells.
Clause 12. The method according to clause 11, further comprising:
   storing the first data in a first storage region of a memory area;
   storing the second data in a second storage region of the memory area;
   updating the second data in the second storage region to the third data, and storing the third data in the second storage region.
Clause 13. The method according to clause 11 or 12, further comprising:
   updating the first data in the first storage region to the first correction data, and storing the first correction data in the first storage region; and
   updating the first correction data in the first storage region to the second correction data, and storing the second correction data in the first storage region.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. The accompanying claims are intended to cover such forms or modifications as would fall within the scope of the inventions.

## Claims

1. A memory system (1) comprising:
a memory device (30) including a plurality of word lines and a plurality of memory cells (MCO to MCn-1) connected to each of the plurality of word lines (WLO to WLn-1); and
a memory controller (10) that controls a read operation of the memory device, wherein
the memory controller is configured to:
acquire first data (DX1, DX2, DX3) related to threshold voltages of a plurality of selected cells connected to a selected word line among the plurality of word lines,
acquire second data (RD1L, RD1M, RD1U) from a plurality of first adjacent cells connected to a first adjacent word line adjacent to one end of the selected word line among the plurality of word lines,
acquire first correction data (DY1, DY2, DY3) by correcting the first data based on the second data,
acquire third data (RD2L, RD2M, RD2U) from a plurality of second adjacent cells connected to a second adjacent word line adjacent to another end of the selected word line among the plurality of word lines,
acquire second correction data (DZ1, DZ2, DZ3) by correcting the first correction data based on the third data, and
execute soft bit decoding processing on the second correction data to generate read data from the plurality of selected cells.

2. The memory system according to claim 1, wherein
the memory controller includes a memory area, and
the memory controller is configured to:
store the first data in a first storage region of the memory area,
store the second data in a second storage region of the memory area, and
updates the second data in the second storage region to the third data, and stores the third data in the second storage region.

3. The memory system according to claim 2, wherein the memory controller is configured to:
update the first data in the first storage region to the first correction data, and stores the first correction data in the first storage region, and
update the first correction data in the first storage region to the second correction data, and stores the second correction data in the first storage region.

4. A memory system (1) comprising:
a memory device (30) including a plurality of word lines (WLO to WLn-1) and a plurality of memory cells (MCO to MCn-1) connected to each of the plurality of word lines; and
a memory controller (10) including a memory area (160) that stores data acquired from the plurality of memory cells, wherein
the memory controller is configured to:
store first data (DX1, DX2, DX3) related to threshold voltages of a plurality of selected cells connected to a selected word line among the plurality of word lines in a first storage region of the memory area,
store, in a second storage region of the memory area, second data (RD1L, RD1M, RD1U) acquired from a plurality of first adjacent cells connected to a first adjacent word line adjacent to one end of the selected word line among the plurality of word lines,
generate first correction data (DY1, DY2, DY3) by correcting the first data based on the second data,
store the first correction data in the first storage region,
store, in the second storage region, third data (RD2L, RD2M, RD2U) acquired from a plurality of second adjacent cells connected to a second adjacent word line adjacent to another end of the selected word line among the plurality of word lines,
generate second correction data (DZ1, DZ2, DZ3) by correcting the first correction data based on the third data,
store the second correction data in the first storage region, and
execute soft bit decoding processing on the second correction data to generate read data from the plurality of selected cells.

5. The memory system according to any of claims 1 to 4, wherein
the first data includes a plurality of label values corresponding to a threshold voltage of each of the plurality of selected cells, and the memory controller includes a first table indicating a relationship between a threshold voltage state of each of the plurality of first and second adjacent cells and a corrected label value, and
the memory controller is configured to correct the plurality of label values according to the threshold voltage state of each of the plurality of first and second adjacent cells based on the first table.

6. The memory system according to any of claims 1 to 5, wherein
the memory controller is configured to:
generate a first histogram indicating a relationship between a threshold voltage state of each of the plurality of first adjacent cells and a plurality of label values according to the threshold voltages of the plurality of selected cells,
calculate a plurality of first correction values according to the threshold voltage state of each of the plurality of first adjacent cells based on the first histogram,
generate a second histogram indicating a relationship between a threshold voltage state of each of the plurality of second adjacent cells and the plurality of label values according to the threshold voltages of the plurality of selected cells,
calculate a plurality of second correction values according to the threshold voltage state of each of the plurality of second adjacent cells based on the second histogram, and
correct each of the label values based on the plurality of first and second correction values.

7. The memory system according to claim 6, wherein
the memory controller is configured to generate a second table related to the plurality of first and second correction values based on the first and second histograms.

8. The memory system according to claim 7, wherein
the memory controller includes firmware that stores the second table.

9. The memory system according to any of claims 1 to 8, wherein
the memory controller is configured to:
determine a threshold voltage state of each of the plurality of first adjacent cells based on the second data,
correct the first data according to the threshold voltage state of each of the plurality of first adjacent cells,
determine a threshold voltage state of each of the plurality of second adjacent cells based on the third data, and
correct the first correction data according to the threshold voltage state of each of the plurality of second adjacent cells.

10. The memory system according to any of claims 1 to 9, wherein
the memory controller is configured to correct an error in the first data caused by a shift of the threshold voltages of the plurality of selected cells in response to at least one of interference between the plurality of selected cells and the plurality of first adjacent cells or interference between the plurality of selected cells and the plurality of second adjacent cells.

11. A method of controlling a memory system (1), the method comprising:
acquiring first data (DX1, DX2, DX3) related to a threshold voltage of a plurality of selected cells (MCO to MCn-1) connected to a selected word line among a plurality of word lines (WLO to WLn-1),
acquiring second data (RD1L, RD1M, RD1U) from a plurality of first adjacent cells connected to a first adjacent word line adjacent to one end of the selected word line among the plurality of word lines,
acquiring first correction data (DY1, DY2, DY3) by correcting the first data based on the second data,
acquiring third data(RD2L, RD2M, RD2U) from a plurality of second adjacent cells connected to a second adjacent word line adjacent to another end of the selected word line among the plurality of word lines,
acquiring second correction data (DZ1, DZ2, DZ3) by correcting the first correction data based on the third data, and
executing soft bit decoding processing on the second correction data to generate read data from the plurality of selected cells.

12. The method according to claim 11, further comprising:
storing the first data in a first storage region of a memory area;
storing the second data in a second storage region of the memory area;
updating the second data in the second storage region to the third data, and storing the third data in the second storage region.

13. The method according to claim 11 or 12, further comprising:
updating the first data in the first storage region to the first correction data, and storing the first correction data in the first storage region; and
updating the first correction data in the first storage region to the second correction data, and storing the second correction data in the first storage region.
